(19)

Europäisches Patentamt
European Patent Office
Office européen des brevets

(11) **EP 4 684 963 A1**

(12) **EUROPEAN PATENT APPLICATION**
published in accordance with Art. 153(4) EPC

(43) Date of publication:
**28.01.2026 Bulletin 2026/05**

(21) Application number: **24775002.9**

(22) Date of filing: **22.03.2024**

(51) International Patent Classification (IPC):
**B32B 27/32** (2006.01)      **B29C 43/14** (2006.01)
**B29C 43/30** (2006.01)      **B32B 7/022** (2019.01)
**B32B 37/10** (2006.01)

(52) Cooperative Patent Classification (CPC):
**B29C 43/14; B29C 43/30; B32B 7/022;
B32B 27/32; B32B 37/10**

(86) International application number:
**PCT/JP2024/011467**

(87) International publication number:
**WO 2024/195869 (26.09.2024 Gazette 2024/39)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **23.03.2023 JP 2023047359**

(71) Applicant: **FP Corporation
Fukuyama-Shi, Hiroshima, 721-8607 (JP)**

(72) Inventors:
• **NISHIE, Yoshihiro
Fukuyama-shi, Hiroshima 721-8607 (JP)**

• **UENO, Shingo
Fukuyama-shi, Hiroshima 721-8607 (JP)**
• **FUJII, Norihisa
Fukuyama-shi, Hiroshima 721-8607 (JP)**
• **MINAMI, Tetsuya
Tokyo 163-6035 (JP)**
• **HAYASHI, Tetsuya
Fukuyama-shi, Hiroshima 721-8607 (JP)**
• **TANAKA, Ryota
Fukuyama-shi, Hiroshima 721-8607 (JP)**
• **SAITO, Yoshihisa
Tokyo 163-6035 (JP)**

(74) Representative: **Kraus & Lederer PartGmbB
Thomas-Wimmer-Ring 15
80539 München (DE)**

(54) **LAMINATED SHEET, METHOD FOR PRODUCING SAME, SHEET MOLDED ARTICLE, AND SOLAR CELL SHEET**

(57)    It is possible to provide a laminated sheet that is applicable to large molded articles, exhibits excellent rigidity, particularly excellent homogeneity of in-plane rigidity when formed into a large area, and has minimal variation in mechanical properties. The laminated sheet of the present invention has a structure in which layer a, comprising a biaxially oriented polypropylene film, and layer b, comprising an olefin-based resin with a melting point of 110 to 160°C, are alternately laminated. When one side direction of the laminated sheet is defined as an x-direction and a direction perpendicular thereto as a y-direction, a tensile modulus of elasticity in the x-direction and a tensile modulus of elasticity in the y-direction at three positions-namely, a center position in the y-direction, and two positions located 200 mm from this center position in the y-direction-are all within a range of 2000 to 5000 MPa.

FIG. 1

**Description**

TECHNICAL FIELD

The present invention relates to a laminated sheet, a method for producing the same, a sheet molded article, and a solar cell sheet.

This application claims priority based on Japanese Patent Application No. 2023-047359, filed in Japan on March 23, 2023, the content of which is incorporated herein by reference.

BACKGROUND ART

Polypropylene sheets are widely used, particularly for food trays, due to their excellent moldability, heat resistance, and chemical resistance. However, they have not been utilized for large molded articles such as building materials, vehicles, or automotive parts because sheet molded articles lack sufficient mechanical strength. As a results, polypropylene is almost used to obtain molded articles through injection molding. On the other hand, polypropylene sheet molded articles have the advantage of being easily recyclable as monomaterial materials, making them suitable for meeting the recent demand for reducing environmental impact, and their use in industrial products is anticipated.

To enhance the rigidity of polypropylene sheet molded articles, for example, Patent Document 1 discloses a prior art for producing a moldable laminated sheet by laminating multiple two-type three-layer oriented polypropylene films, in which lowmelting-point polypropylene films are positioned on both surface layers of a high-melting-point polypropylene film, and bonding them by heating.

Citation List

Patent Document

Patent Document 1: International Publication WO 2020/75755

SUMMARY OF THE INVENTION

Technical Problem

However, the laminated sheet described in Patent Document 1 is laminated and bonded using a roll forming machine, which involves pressing only at the contact point between the nip rolls, making lamination difficult. The adhesion between layers is insufficient, leading to the incorporation of air throughout the sheet, and the resulting sheet is prone to warping or waviness.

Additionally, even when the sheet is fed slowly to ensure bonding, issues such as wrinkles forming on the surface layer due to radiant heat from the roll (165°C) have arisen.

Furthermore, problems such as incorporation of air throughout the sheet, warping, and waviness have been factors that make it difficult to apply the sheet to large-area molding sheets, such as those used in mobility applications.

Therefore, the problem to be solved by the present invention is to provide a biaxially oriented laminated sheet that exhibits excellent rigidity applicable to large molded articles, particularly with homogenized in-plane rigidity when formed into a large area, and minimal variation in mechanical properties.

Additionally, it is to provide a biaxially oriented laminated sheet that exhibits excellent surface smoothness and minimal unevenness in surface irregularities over a wide in-plane area.

Solution to Problem

The content of the present disclosure includes the following embodiments.

[1] A laminated sheet having a structure in which layer a, comprising a biaxially oriented polypropylene film, and layer b, comprising an olefin-based resin with a melting point of 110 to 160°C, are alternately laminated, wherein, when one side direction of the laminated sheet is denoted as an x-direction and a direction perpendicular thereto is denoted as a y-direction, a tensile modulus of elasticity in both the x-direction and the y-direction at three positions-namely, a center position in the y-direction, and two positions located 200 mm from this center position in the y-direction-are all within a range of 2000 to 5000 MPa.

[2] The laminated sheet according to [1], wherein, in a plan view of the laminated sheet, when a 595 mm × 595 mm square is drawn such that an intersection of diagonals corresponds to the center position in the y-direction, the intersection of the diagonals is denoted as $\alpha$, a midpoint between the intersection and a corner along the diagonal is denoted as $\beta$, and the corner is denoted as $\gamma$, and

when a surface roughness at positions $\alpha$, $\beta$, and $\gamma$ is denoted as Ra($\alpha$), Ra($\beta$), and Ra($\gamma$), respectively, Ra($\alpha$), Ra($\beta$), and Ra($\gamma$) satisfy the following expressions (1) and (2):

$$\mathrm{Ra}(\alpha) - \mathrm{Ra}(\beta) < 0.3 \quad (1)$$

$$\mathrm{Ra}(\alpha) - \mathrm{Ra}(\gamma) < 0.3 \quad (2)$$

wherein Ra($\alpha$), Ra($\beta$), and Ra($\gamma$) are average values (average roughness) of surface roughness measured at two locations on each of test piece $\alpha$, test piece $\beta$, and test piece $\gamma$, respectively, which are strip-shaped test pieces cut out with the x-direction as a long side from positions $\alpha$, $\beta$, and $\gamma$.

[3] The laminated sheet according to [1] or [2], wherein the laminated sheet is formed by laminating and heat-fusing a plurality of multilayer biaxially oriented films (X), each comprising a biaxially oriented polypropylene film (A) constituting the layer a and a biaxially oriented olefin-based resin film (B) constituting the layer b laminated on at least one surface of the film (A), and
the multilayer biaxially oriented film (X) has a stretch ratio in an MD direction of 2.8 to 8 times and a stretch ratio in a TD direction of 2.8 to 12 times.
[4] The laminated sheet according to [3], wherein the multilayer biaxially oriented film (X) is a BAB-type film comprising the biaxially oriented olefin-based resin film (B) on both surfaces of the biaxially oriented polypropylene film (A), and has a thickness of 30 to 80 $\mu$m, and
the laminated sheet is formed by laminating 30 to 60 sheets of the BAB-type film, with a BA-type film or a BAA-type film laminated on both surfaces such that the A layer is on the surface.
[5] The laminated sheet according to [4], wherein the multilayer biaxially oriented film (X) is a BAB-type film comprising the biaxially oriented olefin-based resin film (B) on both surfaces of the biaxially oriented polypropylene film (A), and is a two-type three-layer film with a thickness of 100 to 400 $\mu$m, and
the laminated sheet is formed by laminating 2 to 20 sheets of the BAB-type film, with a BA-type film or a BAA-type film laminated on both surfaces such that the A layer is on the surface.
[6] A molded article of the laminated sheet according to [1] or [2].
[7] A method for producing a laminated sheet having a structure in which layer a, comprising a biaxially oriented polypropylene film, and layer b, comprising an olefin-based resin with a melting point of 110 to 160°C, are alternately laminated, the method comprising:

a preparation step of stacking a plurality of multilayer biaxially oriented films (X), each comprising a biaxially oriented polypropylene film (A) constituting the layer a and a biaxially oriented olefin-based resin film (B) constituting the layer b laminated on at least one surface of the film (A), to form a laminated sheet precursor (pMS); and
a press step of heat-pressing the laminated sheet precursor (pMS) with a planar mold.

[8] A method for producing a laminated sheet having a structure in which layer a, comprising a biaxially oriented polypropylene film, and layer b, comprising an olefin-based resin with a melting point of 110 to 160°C, are alternately laminated, the method comprising:

a preparation step of stacking a plurality of multilayer biaxially oriented films (X), each comprising a biaxially oriented polypropylene film (A) constituting the layer a and a biaxially oriented olefin-based resin film (B) constituting the layer b laminated on at least one surface of the film (A), to form a laminated sheet precursor (pMS); and
a press step of continuously heat-pressing the laminated sheet precursor (pMS) using a continuous pressing device, followed by cooling,
wherein the continuous pressing device has multiple heating zones and a cooling zone, and in the heating zone, the laminated sheet precursor (pMS) is heat-pressed with upper and lower planar molds, followed by continuous pressing in the cooling zone with upper and lower planar molds.

[9] The method for producing a laminated sheet according to [8], wherein the laminated sheet precursor (pMS) is inserted between upper and lower planar molds constituting the heating zone of the continuous pressing device,

pressed under conditions of 110 to 170°C and a pressure of 1 to 40 MPa, then, after press release, the sheet is advanced a predetermined length in a machine direction (MD direction), heated and pressed again, and this process is repeated to continuously transfer the sheet from the heating zone to the cooling zone, followed by pressing in the cooling zone under conditions of 25 to 125°C and a pressure of 1 to 40 MPa, and, after press release, the sheet is advanced in the predetermined machine direction to continuously extract the heat-fused laminated sheet.

[10] The method for producing a laminated sheet according to [9], wherein the heating zone is divided into 2 to 10 stages in the MD direction, composed of molds with planar contact surfaces that sandwich the sheet from above and below, and

the cooling zone is divided into 1 or 2 to 5 stages in the MD direction, composed of molds with planar contact surfaces that sandwich the sheet from above and below.

[11] The method for producing a laminated sheet according to [9] or [10], wherein temperature conditions of the heating zone, divided into 2 to 10 stages in the MD direction, are such that a temperature of a first heating zone closest to a sheet inlet is 110 to 160°C, a temperature of a second heating zone following it is +10 to +40°C relative to a set temperature of the first heating zone, and a maximum temperature of the heating zone is 170°C.

[12] The method for producing a laminated sheet according to [7] or [8], wherein the multilayer biaxially oriented film (X) has a stretch ratio in an MD direction of 2.8 to 8 times and a stretch ratio in a TD direction of 2.5 to 12 times.

[13] The method for producing a laminated sheet according to [12], wherein the multilayer biaxially oriented film (X) is a BAB-type film in which the biaxially oriented olefin-based resin film (B) is adhered to both surfaces of the biaxially oriented polypropylene film (A),

a thickness of the biaxially oriented polypropylene film (A) is 30 to 80 $\mu$m, and
the laminated sheet precursor (pMS) is formed by laminating 30 to 60 sheets of the BAB-type film, with a BA-type film or a BAA-type film laminated on both surfaces such that the A layer is on the surface.

[14] The method for producing a laminated sheet according to [7], wherein a sheet-fed vacuum lamination device having planar metal plates above and below within a chamber is used, the laminated sheet precursor (pMS) is placed on a lower metal plate in the chamber, the chamber is set to a vacuum degree of 170 Pa or less, heat-pressed, and, after press release, the sheet is sandwiched between cooling metal plates.

[15] The method for producing a laminated sheet according to [14], wherein the heat-pressing is performed under conditions of a metal plate temperature of 140 to 160°C and a cylinder pressure of 0.1 to 1 MPa.

[16] A solar cell sheet formed by laminating a flexible solar cell module onto the laminated sheet according to any one of [1] to [5].

Advantageous Effects of Invention

According to the present invention, it is possible to provide a biaxially oriented laminated sheet with excellent rigidity applicable to large molded articles, particularly a biaxially oriented laminated sheet in which in-plane rigidity is homogenized when formed into a large area, with minimal variation in mechanical properties.

Additionally, it is possible to provide a biaxially oriented laminated sheet with excellent surface smoothness and minimal unevenness in surface irregularities over a wide in-plane area.

BRIEF DESCRIPTION OF THE DRAWINGS

[FIG. 1] A diagram showing a pressing device having a continuous compression molding mechanism.
[FIG. 2] A diagram showing a planar mold having a plurality of thermally partitioned zones, as an example of the continuous compression molding mechanism of the present disclosure.
[FIG. 3] A diagram showing a planar mold having a plurality of thermally partitioned zones, as another example of the continuous compression molding mechanism of the present disclosure.
[FIG. 4] A diagram showing the temperature settings of the upper and lower molds in the pressing device in Example 1.
[FIG. 5] A plan view of the transparent laminated sheet obtained in Example 1, showing the cutting positions of test pieces for evaluating mechanical properties.
[FIG. 6] A plan view of the transparent laminated sheet obtained in Example 4 (sheet-fed vacuum lamination), showing the cutting positions of test pieces for evaluating mechanical properties.
[FIG. 7] (a) A diagram showing the shape and size of a dumbbell-shaped test piece for measuring tensile modulus of elasticity. (b) A diagram showing the shape and size of a strip-shaped test piece for measuring flexural modulus of elasticity.

[FIG. 8] A plan view of the transparent laminated sheet obtained in Example 1, showing the cutting positions of test pieces for evaluating surface smoothness.

[FIG. 9] A plan view of the transparent laminated sheet obtained in Example 4 (sheet-fed vacuum lamination), showing the cutting positions of test pieces for evaluating surface smoothness.

[FIG. 10] A diagram showing the size of a test piece for evaluating smoothness.

[FIG. 11] A diagram showing the temperature settings of the upper and lower molds in the pressing device in Example 2.

[FIG. 12] A plan view of the transparent laminated sheet obtained in Example 2, showing the cutting positions of test pieces for evaluating surface smoothness.

[FIG. 13] A plan view of the transparent laminated sheet obtained in Example 2, showing the cutting positions of test pieces for evaluating surface smoothness.

[FIG. 14] A conceptual diagram showing a cross-section of the sheet-fed vacuum lamination device used in Example 4.

[FIG. 15] A conceptual diagram showing a cross-section of the cooling device used in Example 4.

[FIG. 16] A diagram showing the temperature settings of the upper and lower molds in the pressing device in Example 3.

[FIG. 17] A conceptual diagram showing the state before and after lamination in the present invention.

[FIG. 18] A cross-sectional view schematically showing a cross-section of a solar cell sheet according to an embodiment of the present invention.

[FIG. 19] A perspective view showing an example of a solar cell integrated carport using the laminated sheet of the present invention.

## DESCRIPTION OF EMBODIMENTS

Hereinafter, the present invention will be described in further detail. The present invention is not limited to the embodiments described below.

The notation "n1 to n2" means a range including n1 or more and n2 or less.

(Laminated Sheet)

The laminated sheet of the present invention is a laminated sheet in which layer a, comprising a biaxially oriented polypropylene film, and layer b, comprising an olefin-based resin with a melting point of 110 to 160°C, are alternately laminated. In the present invention, when one side direction of the laminated sheet is denoted as an x-direction and a direction perpendicular thereto is denoted as a y-direction, a tensile modulus of elasticity in both the x-direction and the y-direction at three positions --namely, a center position in the y-direction, and two positions located 200 mm from this center position in the y-direction-- are all within a range of 2000 to 5000 MPa.

Additionally, in the present invention, the biaxially oriented film used as the raw material for the laminated sheet is preferably stretched at a ratio of $2.8 \times 2.8$ times or more, particularly $3 \times 3$ times or more. Here, it is desirable that the x-direction and y-direction of the laminated sheet correspond to the stretching directions of the biaxially oriented film, for example, preferably with the MD direction as the x-direction and the TD direction as the y-direction.

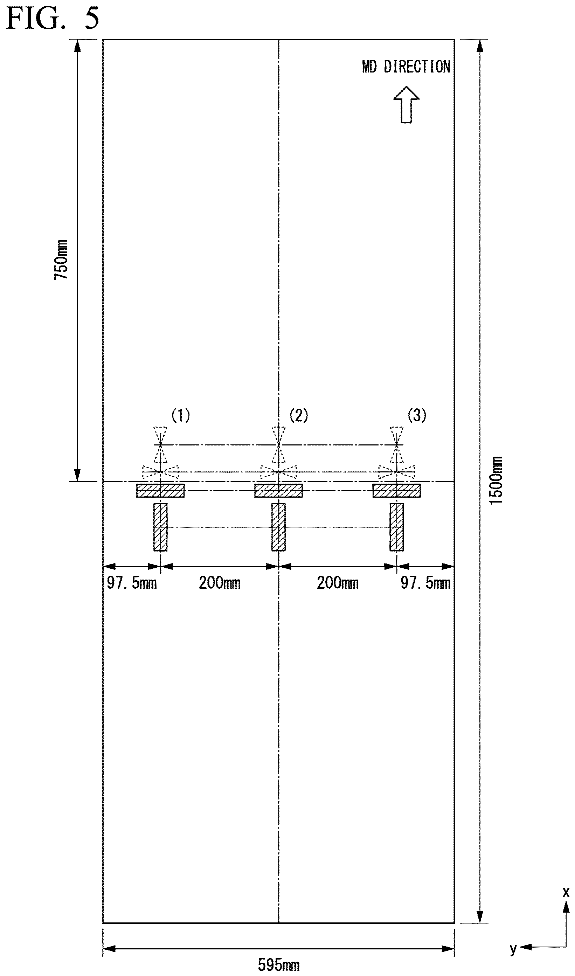

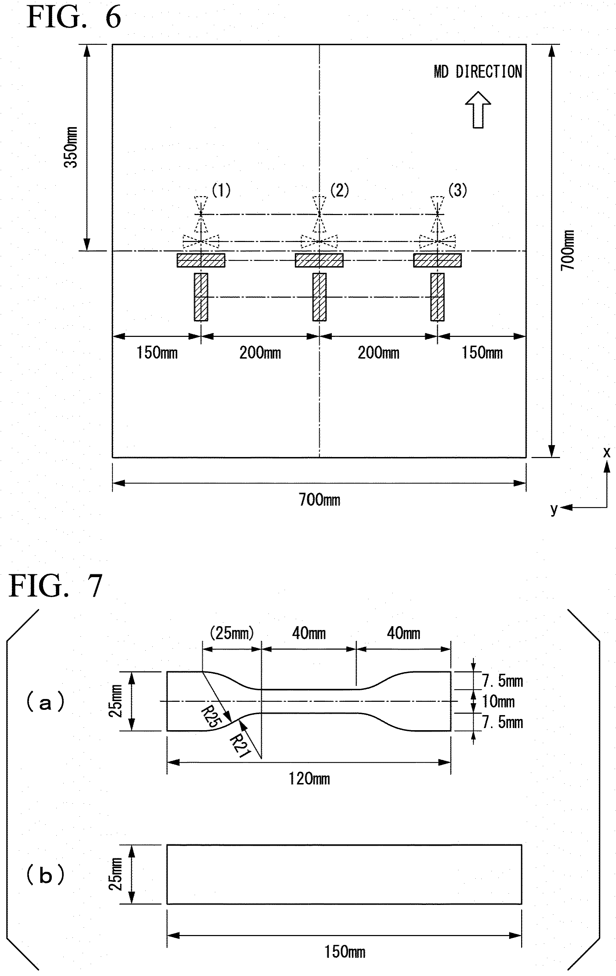

Here, the tensile modulus of elasticity in the x-direction and y-direction at the three positions refers to values evaluated using test pieces cut out centered at these three positions. Specifically, using the example of the laminated sheet shown in FIG. 5 obtained in Example 1 described later, the three positions are, for example, when the sheet longitudinal direction is denoted as the x-direction (MD direction), a point (2) located at the center of a virtual straight line in the y-direction (TD direction), and points (1) and (3) located 200 mm to the left and right of this point (2), respectively, meaning the three positions (1), (2), and (3). The virtual straight line in the y-direction (TD direction) may be at any position, and the three positions (1), (2), and (3) may be determined by appropriately shifting up or down in the x-direction according to the test piece sampling position. Here, for the tensile modulus of elasticity measurement, as shown by the dotted lines in the figure, dumbbell-shaped test pieces with the y-direction (TD direction) as the long side and dumbbell-shaped test pieces with the x-direction (MD direction) as the long side can be cut out at positions (1), (2), and (3) and used for measuring the flexural modulus of elasticity. The cutting position of the dumbbell-shaped test piece with the y-direction (TD direction) as the long side is such that the center of the longitudinal length of the dumbbell shape coincides with positions (1), (2), or (3), and the cutting position of the dumbbell-shaped test piece with the x-direction (MD direction) as the long side is such that the central axis of the dumbbell shape (e.g., the dashed-dotted line in FIG. 7(a)) coincides with positions (1), (2), or (3). The shape and size of the dumbbell-shaped test piece are shown in FIG. 7(a).

The tensile modulus of elasticity measurement can be conducted in accordance with JIS K7161.

In the present invention, since the tensile modulus of elasticity in both the orthogonal x-direction and y-direction falls within a predetermined range, the sheet is characterized by having minimal variation in mechanical properties and uniform mechanical properties over a wide in-plane area.

In the present invention, the preferred range of the tensile modulus of elasticity varies depending on the film thickness and stretch ratio of the biaxially oriented film used as the raw material. For example, when a film with a thickness of 20 $\mu$m or more and less than 100 $\mu$m is used as the biaxially oriented film forming the non-surface core layer, it is possible to use a film with a high stretch ratio, preferably with a stretch ratio of 2.8 to 8 times in the MD direction and 8 to 12 times in the TD direction. In this case, for a laminated sheet manufactured by Method 1 described later (press method using a continuous pressing device), when the longitudinal direction is denoted as the x-direction:

- Tensile modulus of elasticity in the x-direction (MD direction): 2000 to 3000 MPa
- Tensile modulus of elasticity in the y-direction (TD direction): 3000 to 5000 MPa

is preferable.

For a laminated sheet manufactured by Method 2 described later (sheet-fed press method), when one side direction is denoted as the x-direction:

- Tensile modulus of elasticity in the x-direction: 2000 to 3000 MPa
- Tensile modulus of elasticity in the y-direction: 3000 to 5000 MPa

is preferable.

Particularly, when manufacturing by Method 2 (sheet-fed press method), when the MD direction/TD direction of the raw material oriented film is aligned and laminated:

- Tensile modulus of elasticity in the x-direction (raw material film MD direction): 2000 to 3000 MPa
- Tensile modulus of elasticity in the y-direction (raw material film TD direction): 3000 to 5000 MPa

is preferable.

On the other hand, when a film with a thickness of 100 to 400 $\mu$m is used as the raw material oriented film forming the non-surface core layer, the stretch ratio during the production of the raw material oriented film is preferably 2.8 to 8 times, more preferably 3 to 6 times in the MD direction, and 2.8 to 8 times, more preferably 3 to 6 times in the TD direction. In this case, for a laminated sheet manufactured by Method 1 (press method using a continuous pressing device), when the longitudinal direction is denoted as the x-direction:

- Tensile modulus of elasticity in the x-direction (MD direction): 2000 to 3200 MPa
- Tensile modulus of elasticity in the y-direction (TD direction): 2000 to 3200 MPa

is preferable.

Additionally, for the three tensile modulus of elasticity values evaluated in the y-direction at the three positions, it is preferable that the coefficient of variation is 6% or less from the viewpoint of excellent uniformity in sheet rigidity, particularly preferably 5% or less, and especially preferably 4.5% or less. The coefficient of variation may be 0.5% or more.

Here, the coefficient of variation is a value calculated as [(standard deviation / average) $\times$ 100 (%)].

Additionally, for the three tensile modulus of elasticity values evaluated in the x-direction at the three positions, it is preferable that the coefficient of variation is 3% or less, more preferably 2.5% or less, and particularly preferably 2% or less. The coefficient of variation may be 0.2% or more.

Furthermore, the flexural modulus of elasticity at the three positions can be explained using, for example, the laminated sheet shown in FIG. 5 obtained in Example 1 described later. As shown in FIG. 5, strip-shaped test pieces with the y-direction as the long side and strip-shaped test pieces with the x-direction as the long side can be cut out at positions (1), (2), and (3) and used for flexural modulus of elasticity measurement. For strip-shaped test pieces with the y-direction as the long side, the midpoint of the long side of the test piece coincides with the three positions (1), (2), or (3), and for strip-shaped test pieces with the x-direction as the long side, the midpoint of the short side of the test piece coincides with the three positions (1), (2), or (3). The shape and size of the strip-shaped test piece are shown in FIG. 7(b). The flexural modulus of elasticity measurement can be conducted in accordance with JIS K7171.

Specifically, when a biaxially oriented film with a thickness of 20 $\mu$m or more and less than 100 $\mu$m, stretched 2.8 to 8 times in the MD direction and 8 to 12 times in the TD direction, is used as the raw material forming the non-surface core layer, and for a laminated sheet manufactured by Method 1 (press method using a continuous pressing device), when the longitudinal direction is denoted as the x-direction:

- Flexural modulus of elasticity in the x-direction (MD direction): 2000 to 3500 MPa
- Flexural modulus of elasticity in the y-direction (TD direction): 3500 to 6000 MPa

is preferable.

For a laminated sheet manufactured by Method 2 (sheet-fed press method), when one side direction is denoted as the x-direction:

- Flexural modulus of elasticity in the x-direction: 2000 to 3500 MPa
- Flexural modulus of elasticity in the y-direction: 3500 to 6000 MPa

is preferable.

Particularly, when the MD direction/TD direction of the raw material oriented film is aligned and laminated:

- Flexural modulus of elasticity in the x-direction (raw material film MD direction): 2000 to 3500 MPa
- Flexural modulus of elasticity in the y-direction (raw material film TD direction): 3500 to 6000 MPa

is preferable.

On the other hand, when a biaxially oriented film with a thickness of 100 to 400 $\mu$m, stretched 2.8 to 8 times, preferably 3 to 6 times in the MD direction, and 2.8 to 8 times, preferably 3 to 6 times in the TD direction, is used as the raw material forming the non-surface core layer, and for a laminated sheet manufactured by Method 1 (press method using a continuous pressing device):

- Flexural modulus of elasticity in the x-direction (MD direction): 2500 to 3500 MPa
- Flexural modulus of elasticity in the y-direction (TD direction): 2500 to 3500 MPa

is preferable.

Additionally, for the three flexural modulus of elasticity values evaluated in the y-direction at the three positions, it is preferable that the coefficient of variation is 6.5% or less, more preferably 5.5% or less, and particularly preferably 4.8% or less. The coefficient of variation may be 0.5% or more.

Additionally, for the three flexural modulus of elasticity values evaluated in the x-direction at the three positions, it is preferable that the coefficient of variation is 4% or less, more preferably 3.5% or less, and particularly preferably 3% or less. The coefficient of variation may be 0.2% or more.

Since the laminated sheet of the present invention is characterized by being homogeneous in mechanical properties over a large area, as described above, it is preferable that the length of one side is 400 mm or more, particularly 500 mm or more, 600 mm or more, 1300 mm or more, or 2000 mm or more. Especially when manufacturing the laminated sheet by Method 1 (press method using a continuous pressing device) described below, when the sheet feed direction is denoted as the x-direction, the length in the y-direction perpendicular thereto, i.e., the laminated sheet width, can be 400 mm or more, 500 mm or more, 600 mm or more, 1300 mm or more, or 2000 mm or more. In this case, with Method 1 (press method using a continuous pressing device), if the raw material biaxially oriented film is supplied from a roll, there is no restriction on the length in the x-direction, which can be appropriately selected according to the purpose.

Additionally, it is preferable that the laminated sheet of the present invention further has the following characteristics.

The laminated sheet of the present invention is preferably uniform in surface smoothness from the viewpoint of excellent appearance, and, for example, by laminating a decorative film or sandwiching it between layers, it can be made into a decorative material with excellent aesthetic properties without painting. Specifically, in a plan view of the laminated sheet, when a 595 mm × 595 mm square is drawn such that the intersection of the diagonals corresponds to the center position in the x-direction or y-direction and one side of the square is parallel to one side of the laminated sheet, and when the intersection of the diagonals is denoted as $\alpha$, the midpoint between the intersection and a corner along the diagonal is denoted as $\beta$, and the corner is denoted as $\gamma$, and when the surface roughness at positions $\alpha$, $\beta$, and $\gamma$ is denoted as Ra($\alpha$), Ra($\beta$), and Ra($\gamma$), respectively, it is preferable that the difference ($\Delta$Ra) of Ra($\beta$) or Ra($\gamma$) relative to Ra($\alpha$) satisfies the following expressions (1) and (2).

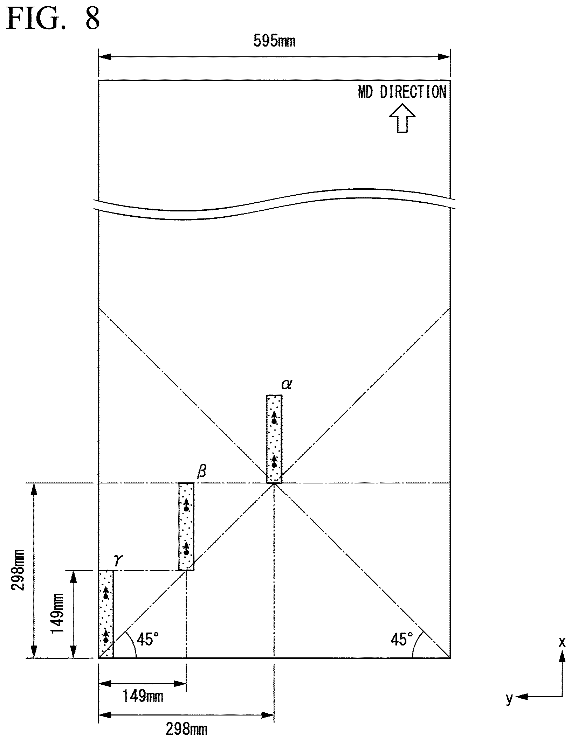

The positions $\alpha$, $\beta$, and $\gamma$ are, for example, as explained using the laminated sheet shown in FIG. 8 obtained in Example 1 described later, the positions $\alpha$, $\beta$, and $\gamma$ shown in FIG. 8.

$$\Delta Ra(\alpha, \beta) = Ra(\alpha) - Ra(\beta) < 0.3 \quad (1)$$

$$\Delta Ra(\alpha, \gamma) = Ra(\alpha) - Ra(\gamma) < 0.3 \quad (2)$$

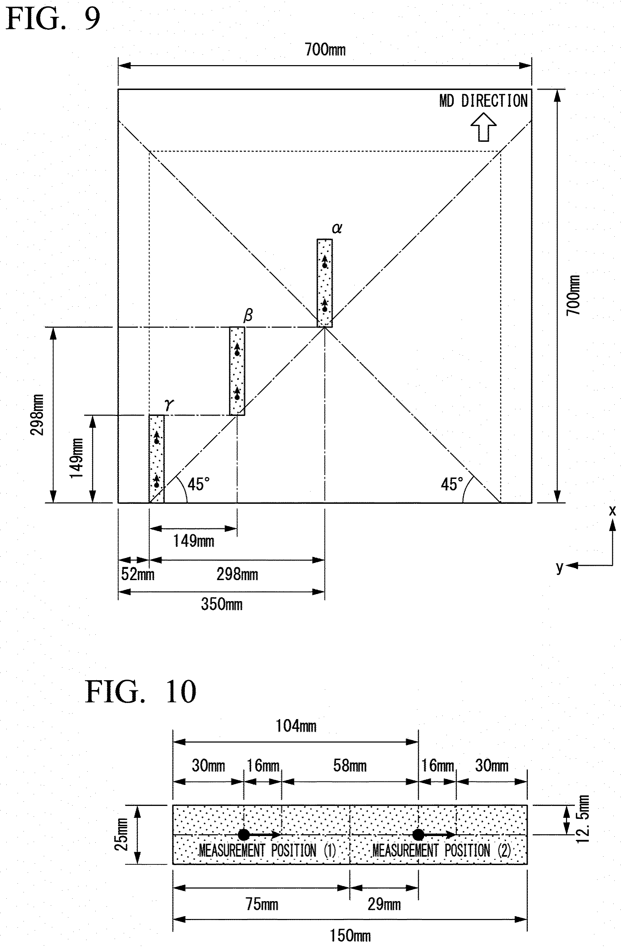

The Ra($\alpha$), Ra($\beta$), and Ra($\gamma$) are the average values (average roughness) of surface roughness measured at two locations on each of test piece $\alpha$, test piece $\beta$, and test piece $\gamma$, respectively, which are strip-shaped test pieces cut out with the MD direction as the long side from positions α, β, and γ. The test piece is, for example, as shown in FIG. 10. The two measurement positions on one test piece include measurement position (1) and measurement position (2) shown in FIG. 10.

Additionally, with Ra(α) as the reference, the relative roughness ΔRa(β) and ΔRa(γ) at β and γ can be expressed as follows:

$$\Delta Ra(\beta) = [(Ra(\beta) - Ra(\alpha)) / Ra(\alpha)] \times 100 \quad (3)$$

$$\Delta Ra(\gamma) = [(Ra(\gamma) - Ra(\alpha)) / Ra(\alpha)] \times 100 \quad (4)$$

It is preferable that ΔRa(β) is 100% or less, and ΔRa(γ) is 100% or less.

The biaxially oriented film used as the raw material for the laminated sheet of the present invention may be prepared by individually preparing the biaxially oriented polypropylene film (A) constituting the layer a and the biaxially oriented olefin-based resin film (B) constituting the layer b, but it is preferable to use it as a multilayer biaxially oriented film (X) including the biaxially oriented polypropylene film (A) constituting the layer a and the biaxially oriented olefin-based resin film (B) constituting the layer b laminated on at least one surface of the film (A). Here, the multilayer biaxially oriented film (X) is particularly preferably manufactured by a co-extrusion method from the viewpoint of excellent adhesion between (A) and (B). That is, in the present invention, it is preferable to manufacture the laminated sheet by stacking and heat-fusing a plurality of multilayer biaxially oriented films (X). Therefore, the stretch ratios in the MD direction and TD direction of the raw material biaxially oriented film are preferably the stretch ratios of the multilayer biaxially oriented film (X).

In the present invention, as described above, it is preferable that the raw material biaxially oriented film, particularly the multilayer biaxially oriented film (X), has a stretch ratio of 2.8 to 8 times in the MD direction and 2.8 to 12 times in the TD direction, as this allows the biaxially oriented polypropylene film (A) in the laminated sheet to maintain high orientation, which is advantageous for rigidity. Such a laminated sheet of the present invention can be produced by the producing method described in the "Method for Producing the Laminated Sheet" described later.

The multilayer biaxially oriented film (X) includes an AB-type film in which a biaxially oriented olefin-based resin film (B) is laminated on one surface of a biaxially oriented polypropylene film (A), an AAB-type film in which a film (A) and further a film (B) are laminated on one surface of a biaxially oriented polypropylene film (A), and a BAB-type film in which a film (B) is laminated on both surfaces of a biaxially oriented polypropylene film (A), and these can be used in appropriate combinations. It is particularly preferable to stack a plurality of BAB-type films and laminate an AB-type film or an AAB-type film on both surfaces such that the A layer is on the surface.

The size of the laminated sheet of the present invention can be appropriately selected according to the application. Since the present invention has the unprecedented feature of enabling large-area sheets with high rigidity, as described above, it is preferable that the length of one side is 400 mm or more, particularly 500 mm or more, 600 mm or more, 1300 mm or more, or 2000 mm or more. Especially when manufacturing the laminated sheet by Method 1 (press method using a continuous pressing device) described below, when the sheet feed direction is denoted as the x-direction, the length in the y-direction perpendicular thereto, i.e., the laminated sheet width, can be 400 mm or more, 500 mm or more, 600 mm or more, 1300 mm or more, or 2000 mm or more. However, it is preferable that at least one side of the laminated sheet has a length of 500 to 2000 mm, with the length of the side perpendicular thereto being equal to or greater than that.

For example, in the case of a laminated sheet manufactured by Method 1 (press method using a continuous pressing device) described later, it is preferable that the length in the y-direction (TD direction) is 500 to 2000 mm, and the length in the x-direction (MD direction) is equal to or greater than that. Additionally, according to the manufacturing method (Method 1) described later, since continuous manufacturing is possible, the length in the x-direction (MD direction) can be freely manufactured to several meters, but when used for industrial products, housing, or automotive exterior components, it is preferable that the length in the x-direction (MD direction) is 1000 to 3000 mm from the viewpoint of good processability for secondary molding.

When manufacturing the laminated sheet by Method 2 (sheet-fed press method) described later, since it is manufactured by a batch method, it is preferable that the length of each side (x-direction or y-direction) is 500 to 2000 mm.

(Method for Producing the Laminated Sheet)

As a method for producing the above-described laminated sheet, the method includes:

a preparation step of stacking a plurality of biaxially oriented polypropylene films (A) and biaxially oriented olefin-based resin films (B) alternately to form a laminated sheet precursor (pMS), or stacking a plurality of multilayer biaxially oriented films (X), including a biaxially oriented polypropylene film (A) and a biaxially oriented olefin-based resin film (B) laminated on at least one surface of the film (A), preferably manufactured by a co-extrusion method, to form a laminated sheet precursor (pMS); and

a press step of heat-pressing the laminated sheet precursor (pMS) on a planar surface.

In the present invention, by heat-pressing the laminated sheet precursor (pMS) on a planar surface rather than a roll, it is possible to obtain a laminated sheet with high rigidity, excellent homogeneity, and minimal variation in mechanical properties across different portions.

<Preparation Step of Laminated Sheet Precursor (pMS)>

Specifically, examples of the preparation step of the above-described laminated sheet precursor (pMS) include:

Preparation Step 1: a step of stacking a plurality of biaxially oriented polypropylene films (A) and biaxially oriented olefin-based resin films (B) alternately to form a laminated sheet precursor (pMS); and

Preparation Step 2: a step of stacking a plurality of multilayer biaxially oriented films (X), including a biaxially oriented polypropylene film (A) and a biaxially oriented olefin-based resin film (B) laminated on at least one surface of the film (A), to form a laminated sheet precursor (pMS).

Among these, Preparation Step 2 is particularly preferable from the viewpoint of excellent adhesion between (A) and (B). Additionally, the multilayer biaxially oriented film (X) may be manufactured by laminating a biaxially oriented polypropylene film (A) and a biaxially oriented olefin-based resin film (B), but it is preferably manufactured by a co-extrusion method from the viewpoint of achieving excellent interlayer adhesion.

Here, the biaxially oriented polypropylene film (A) preferably has a stretch ratio of 2.8 to 8 times in the MD direction and 2.8 to 12 times in the TD direction during its production. Meanwhile, the biaxially oriented olefin-based resin film (B) preferably has a stretch ratio of 2.8 to 8 times in the MD direction and 2.5 to 12 times in the TD direction, as this significantly improves the rigidity of the resulting laminated sheet and provides appropriate secondary moldability.

When manufacturing the multilayer biaxially oriented film (X) by a co-extrusion method, in the case of producing a film with a thickness of 20 $\mu$m or more and less than 100 $\mu$m, it is possible to achieve a high stretch ratio for the film itself, and it is preferable that the stretch ratio during the production of the raw material film is 2.8 to 8 times in the MD direction and 8 to 12 times in the TD direction, as this results in excellent rigidity of the laminated sheet. Additionally, biaxial stretching can be performed by sequential stretching or simultaneous stretching. On the other hand, when producing a film with a thickness of 100 to 400 $\mu$m, the stretch ratio during the production of the film is preferably 2.8 to 8 times in the MD direction and 2.8 to 8 times in the TD direction, particularly preferably 3 to 6 times in the MD direction and 3 to 6 times in the TD direction.

Additionally, examples of the multilayer biaxially oriented film (X) include: a BA-type film in which a biaxially oriented olefin-based resin film (B) is laminated on one surface of a biaxially oriented polypropylene film (A); a BAA-type film in which two biaxially oriented polypropylene films (A) are stacked and a biaxially oriented olefin-based resin film (B) is laminated on one surface thereof; a BAB-type film in which a biaxially oriented olefin-based resin film (B) is laminated on both surfaces of a biaxially oriented polypropylene film (A); and a BAC-type film in which a biaxially oriented olefin-based resin film (B) is laminated on one surface of a biaxially oriented polypropylene film (A) and a modified polypropylene-based resin film (C) is laminated on the other surface.

Such multilayer biaxially oriented films (X) can be appropriately selected and combined according to the purpose to obtain the precursor (pMS). In the present invention, it is preferable to stack a plurality of BAB-type films and laminate BA-type films or BAA-type films on both surfaces such that the A layer is on the surface, as shown below.

AB/BAB/BAB/BAB/.../BAB/BAB/BAB/BA

AAB/BAB/BAB/BAB/.../BAB/BAB/BAB/BAA

Alternatively, when further laminating a decorative film or applying printing, it is preferable to use a BAC-type film on the surface such that the C layer is on the surface, as shown below, to form the laminating surface or printing surface.

CAB/BAB/BAB/BAB/.../BAB/BAB/BAB/BAA

Examples of the multilayer biaxially oriented film (X), for example, the BAB-type film, include a two-type three-layer film (x1) with a thickness of 30 $\mu$m or more and less than 100 $\mu$m, and a two-type three-layer film (x2) with a thickness of 100 to 400 $\mu$m.

Additionally, the thickness ratio of B/A/B in the BAB-type film is preferably, for example, B/A/B = 2 to 20/96 to 60/2 to 20, but from the viewpoint of enhancing rigidity, it is desirable to ensure the thickness of the A layer as much as possible, particularly preferably B/A/B = 2 to 15/96 to 70/2 to 15.

When the multilayer biaxially oriented film (X) is a two-type three-layer film (x1) with a thickness of 30 $\mu$m or more

and less than 100 $\mu$m, it is preferable to stack 30 to 60 sheets and laminate a BA-type film or a BAA-type film on the surface such that the A layer is on the surface. Alternatively, when printing or laminating a decorative film on the laminated sheet, it is preferable to stack a BAC-type film such that the C layer is on the surface instead of a BA-type film or a BAA-type film.

On the other hand, when the multilayer biaxially oriented film (X) is a two-type three-layer film (x2) with a thickness of 100 to 400 $\mu$m, it is preferable to stack 2 to 20 sheets and laminate a BA-type film or a BAA-type film on the surface such that the A layer is on the surface. Alternatively, when printing or laminating a decorative film on the laminated sheet, it is preferable to stack a BAC-type film such that the C layer is on the surface instead of a BA-type film or a BAA-type film.

The thickness of the BA-type film is preferably 20 to 300 $\mu$m, and the thickness ratio [B/A] is preferably 5 to 20/95 to 80. The thickness of the BAA-type film is preferably 30 to 300 $\mu$m, and the thickness ratio [B/A/A] is preferably 5 to 20/95 to 80/95 to 80. The thickness of the BAC-type film is preferably 30 to 300 $\mu$m, and the thickness ratio [B/A/C] is preferably 2 to 20/96 to 60/2 to 20.

The size of the laminated sheet precursor (pMS) in the present invention can be appropriately selected according to the size of the laminated sheet to be manufactured in the press step of Method 1 (press method using a continuous pressing device) or Method 2 (sheet-fed press method) described later.

When stacking the multilayer biaxially oriented films (X), they may be stacked with their MD direction/TD direction aligned, or stacked so that they cross each other. However, when manufacturing the laminated sheet by Method 1 (press method using a continuous pressing device), it is preferable to stack them with the MD direction/TD direction aligned, as the multilayer biaxially oriented films (X) can be supplied from a roll to a continuous press machine.

On the other hand, when manufacturing the laminated sheet by Method 2 (sheet-fed press method) described later, it is preferable to stack them with the MD direction/TD direction aligned from the viewpoint of workability and productivity. However, from the viewpoint of orientation homogeneity, it is preferable to stack them so that they cross each other.

(Biaxially Oriented Polypropylene Film (A))

The biaxially oriented polypropylene film (A) can be obtained by biaxially stretching a polypropylene-based polymer or a polypropylene composition containing the polypropylene-based polymer and a nucleating agent or other additives using a known method.

For example, the polypropylene or the like can be extruded to obtain an unoriented sheet, and the sheet can be biaxially stretched to obtain a biaxially oriented film. However, as described above, in the present invention, it is preferable to form and stretch the film together with other layers by a co-extrusion method.

The polypropylene-based polymer used here specifically includes a propylene homopolymer, a propylene random copolymer obtained by polymerizing a monomer component containing at least one selected from C2 to C10 $\alpha$-olefins (excluding C3 $\alpha$-olefin) in an amount of 1 mass% or less, and mixtures thereof.

Among these, a propylene random copolymer obtained by polymerizing a monomer component containing 1 mass% or less of ethylene (hereinafter sometimes simply referred to as "propylene random copolymer") is particularly preferable, as it can impart excellent stretchability while maintaining high rigidity and toughness in the sheet.

The polypropylene-based polymer preferably has a relatively broad molecular weight distribution with Mw/Mn of 6 to 20, as this provides excellent thickness accuracy, enables both high rigidity and high stretchability, and facilitates film formation.

Additionally, the amount of xylene-insoluble fraction in the polypropylene-based polymer is preferably more than 96.5 mass% and 99.5 mass% or less. The xylene-insoluble component in polypropylene corresponds to the crystalline isotactic component. In contrast, the xylene-soluble component, present in small amounts in polypropylene, corresponds to the non-crystalline atactic component and has a lower molecular weight compared to the xylene-insoluble component. The amount of xylene-insoluble fraction being more than 96.5 mass% and 99.5 mass% or less means that the crystalline component of the polypropylene-based resin material is in this range. From the viewpoint of achieving excellent rigidity and heat resistance, particularly rigidity, in a (secondary) molded article obtained by thermoforming the sheet, the amount of xylene-insoluble fraction is particularly preferably more than 97.0 mass% and 99.5 mass% or less.

Additionally, the crystalline component of the polypropylene-based polymer preferably has a stereoregularity (mmmm) of 97.5 to 99.5%. If mmmm is less than 97.5%, the rigidity and heat resistance, particularly heat resistance, of a (secondary) molded article obtained by thermoforming a sheet comprising the polypropylene composition will be reduced.

When the propylene random copolymer is used as the polypropylene-based polymer, the ethylene content in the raw material monomer component is preferably 0.1 mass% or more and less than 1 mass%, more preferably 0.1 mass% or more and less than 0.6 mass%, and particularly preferably 0.1 mass% or more and less than 0.3 mass%, from the viewpoint of enhancing stretchability while maintaining the toughness and rigidity of the sheet.

The propylene random copolymer has the characteristic of improved transparency by randomly copolymerizing ethylene with propylene. Furthermore, an ethylene content of less than 1 mass% in the raw material monomer component results in excellent rigidity. The lower limit of the ethylene content is not particularly limited and may be more than 0 mass%, but from the viewpoint of sufficiently achieving the transparency enhancement effect, 0.1 mass% or more is preferable.

The MFR of the polypropylene-based polymer is 1 to 15 g/10 min, preferably 2 to 6 g/10 min. When the MFR is within this range, the moldability when forming the polypropylene composition into a sheet is excellent.

It is preferable to use the polypropylene-based polymer as a polypropylene composition containing a nucleating agent from the viewpoint of transparency, but in the present invention, using a smaller amount of nucleating agent than usual can further improve transparency by reducing haze.

The content of the nucleating agent in the polypropylene composition is preferably less than 0.18 parts by mass per 100 parts by mass of the ethylene-containing polypropylene-based polymer, particularly preferably 0.15 parts by mass or less. When the content is less than this upper limit, excellent thickness accuracy is easily achieved, and the polypropylene composition exhibits excellent film-forming properties while maintaining strength and rigidity. The lower limit of the nucleating agent content is not particularly limited, but from the viewpoint of transparency enhancement, 0.01 parts by mass or more is preferable.

The polypropylene composition of the present invention preferably has a crystallization rate parameter (t1/2) exceeding 1 second, more preferably 2 seconds or more. Reducing the amount of nucleating agent tends to decrease the crystallization rate, increasing t1/2. When t1/2 exceeds this lower limit, excellent thickness accuracy is easily achieved. The upper limit of t1/2 is not particularly limited but is preferably about 5 seconds or less.

[Nucleating Agent]

The amount of the nucleating agent is preferably more than 0 parts by weight and 1.0 parts by weight or less, preferably 0.05 to 0.5 parts by weight, per 100 parts by weight of polypropylene. The nucleating agent is an additive (transparent nucleating agent) used to control the size of crystalline components in the resin to enhance transparency. The nucleating agent is not particularly limited, and those commonly used in the field may be used, but it is preferably selected from nonitol-based nucleating agents, sorbitol-based nucleating agents, phosphate ester-based nucleating agents, triaminobenzene derivative nucleating agents, carboxylate metal salt nucleating agents, and xylitol-based nucleating agents. Examples of nonitol-based nucleating agents include 1,2,3-trideoxy-4,6:5,7-bis-[(4-propylphenyl)methylene]-nonitol. Examples of sorbitol-based nucleating agents include 1,3:2,4-bis-o-(3,4-dimethylbenzylidene)-D-sorbitol. Examples of phosphate ester-based nucleating agents include lithium 2,2'-methylenebis(4,6-di-tert-butylphenyl) phosphate-based nucleating agents.

[Other Additives]

The polypropylene composition of the present invention may contain other additives besides the nucleating agent, within a range that does not impair the effects of the present invention.

Examples of other additives include conventional additives commonly used for polyolefins, such as antioxidants, neutralizers, chlorine absorbers, heat stabilizers, light stabilizers, ultraviolet absorbers, internal lubricants, external lubricants, anti-blocking agents, antistatic agents, antifogging agents, flame retardants, dispersants, copper corrosion inhibitors, plasticizers, crosslinking agents, peroxides, oils, and other organic and inorganic pigments. The amount of each additive may be a known amount.

[Preparation of Polypropylene-Based Polymer or Polypropylene Composition]

The polypropylene-based polymer or polypropylene composition described above in detail can be prepared, for example, by Production Examples 2 to 7 of Patent No. 6845001.

<Biaxially Oriented Olefin-Based Resin Film (B)>

The biaxially oriented olefin-based resin film (B) with a melting point of 110 to 160°C, used in the method for producing the laminated sheet of the present invention, can be obtained by biaxially stretching an olefin-based resin or an olefin-based resin composition containing the olefin-based resin and additives using a known method. For example, the olefin-based resin or the like can be extruded to obtain an unoriented sheet, and the sheet can be biaxially stretched to obtain a biaxially oriented film. However, as described above, in the present invention, it is preferable to form and stretch the film together with other layers by a co-extrusion method.

The olefin-based resin constituting the biaxially oriented olefin-based resin film (B) has a melting point of 110 to 160°C. Here, the melting point is measured using DSC at a heating rate of 10°C/min from 30°C to 230°C. With such a melting point range, the melting point is sufficiently lower than that of the polypropylene constituting the A layer, resulting in excellent fusion properties during heat-pressing. Specifically, the olefin-based resin is preferably formed from a propylene homopolymer (HOMO), a propylene random copolymer (RACO) containing at least one comonomer selected from C2 to

C10 $\alpha$-olefins (excluding C3 $\alpha$-olefin) in an amount of 5 mass% or less, or a resin composition containing HOMO or RACO. If the comonomer content is too low, the fusion properties with the first layer may be insufficient, and if too high, the rigidity of the laminated sheet may be reduced. From this viewpoint, the comonomer content is preferably more than 0 mass% and 4.5 mass% or less. Ethylene (C2 $\alpha$-olefin) is preferable as the comonomer. The MFR (230°C, 2.16 kg load) of the polymer or resin composition constituting the second layer is not limited but is preferably 1 to 15 g/10 min, more preferably 2 to 10 g/10 min, and particularly preferably 3 to 8 g/10 min.

The olefin-based resin or the like may contain a nucleating agent or may be composed of a resin composition or polymer without a nucleating agent. When a nucleating agent is included, from an economic viewpoint, the amount of the nucleating agent is preferably 1 part by weight or less per 100 parts by weight of the polymer forming the second layer. Therefore, the biaxially oriented olefin-based resin film (B) is preferably composed of a resin composition containing HOMO and a nucleating agent or RACO and a nucleating agent.

The thickness of the biaxially oriented olefin-based resin film is preferably 1 to 20 $\mu$m per layer, particularly preferably 2 to 10 $\mu$m.

<Modified Olefin-Based Resin Film (C)>

Next, the modified olefin-based resin film (C) can be obtained by biaxially stretching a modified olefin-based resin or an olefin-based resin composition containing the olefin-based resin and additives using a known method. For example, the modified olefin-based resin or the like can be extruded to obtain an unoriented sheet, and the sheet can be biaxially stretched to obtain a biaxially oriented film. However, as described above, in the present invention, it is preferable to form and stretch the film together with other layers by a co-extrusion method.

The modified olefin-based resin constituting the modified olefin-based resin film (C) includes, for example, polypropylene having various functional groups in its molecular structure, such as carboxyl groups, acid anhydride groups, sulfonic acid groups, phosphoric acid groups, phosphate ester groups, imino groups, and amino groups. Polypropylene having carboxyl groups, acid anhydride groups, or imino groups are particularly preferable from the viewpoint of excellent adhesion to the printing layer or other members.

Examples of such functional group-containing modified olefins include "Admer Film QB515," "Admer Film QB550," "Admer Film QF500," "Admer Film QF551," "Admer Film QF580," "Admer Film QE840," and "Admer Film QE060" manufactured by Mitsui Chemicals, Inc.

<Press Step>

The step of heat-pressing the laminated sheet precursor (pMS) obtained as described above can be specifically performed by Method 1 or Method 2 described in detail below.

[Method 1] Continuous Press Method

Method 1 includes a step of continuously heat-pressing the laminated sheet precursor (pMS) with a planar mold using a continuous pressing device, followed by a cooling press step. The planar mold refers to a mold with a planar contact surface.

When Method 1 is employed, the resulting laminated sheet has an excellent surface condition, with reduced surface unevenness such as waviness, and excellent transparency, making it preferable.

Method 1 is described in further detail below.

The continuous pressing device used in Method 1 is a pressing device with a continuous compression molding mechanism (CCM: continuous compression molding), which has multiple heating zones and a cooling zone, a mechanism for heat-pressing the laminated sheet precursor (pMS) with upper and lower planar molds in the heating zone, and a mechanism for continuously cooling and pressing the laminated sheet with upper and lower planar molds in the cooling zone to perform aging.

By using such a continuous pressing device, the degree of freedom in designing the size in the MD direction is enhanced. Additionally, since the sheet is continuously transferred from the heating zone to the cooling zone and pressed, it is possible to obtain a laminated sheet with excellent uniformity in rigidity and strength, as well as superior surface condition and transparency.

A specific method for pressing the laminated sheet precursor (pMS) using the continuous pressing device involves introducing the laminated sheet precursor (pMS) continuously or intermittently into the gap between the upper and lower planar molds constituting the heating zone of the continuous pressing device, heating to 110 to 170°C while pressing under a pressure condition of 1 to 40 MPa, then, after press release, advancing the sheet a predetermined length in a predetermined direction, heat-pressing again, and repeating this process to transfer the sheet continuously or intermittently from the heating zone to the cooling zone, pressing in the cooling zone under temperature conditions of 25 to 125°C and pressure conditions of 1 to 40 MPa, followed by pressure release and transfer, thereby gradually discharging the heat-fused laminated sheet from the gap between the upper and lower planar molds. Here, it is preferable to perform aging in the cooling zone under relatively high temperature conditions, particularly preferably at a temperature condition of 60 to 125°C.

The size (pitch) at which the laminated sheet is advanced during press release is not particularly limited but is preferably in the range of 10 to 300 mm. Additionally, the press release time is preferably 0.5 to 3 seconds from the viewpoint of lamination uniformity.

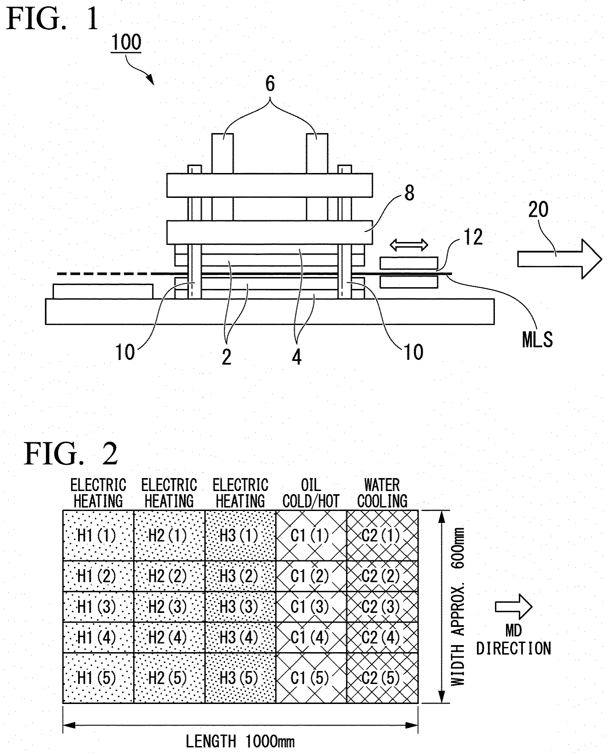

To describe the pressing device with a continuous compression molding mechanism (continuous pressing device) in more detail, the continuous pressing device 100, as shown in FIG. 1, has a pair of upper and lower planar molds 2. Each of the upper and lower molds 2 has a pair of heating/cooling plate modules 4 at their upper and lower parts, respectively, enabling heating or cooling of the pair of molds 2. The upper planar mold is configured to be pressed from above by a hydraulic cylinder 6, a lifting unit 8, and a lifting guide 10.

Additionally, at the front of the mold unit in the direction of travel, there is a pull-out unit 12 that has the function of pulling out the laminated sheet (MLS) by moving back and forth in the MD direction (machine direction).

Here, the pair of upper and lower planar molds 2 is thermally partitioned into a heating zone and a cooling zone in the sheet travel direction (MD direction), and preferably also thermally partitioned in the direction perpendicular to the sheet travel direction (TD direction), for example, as shown in FIG. 2, a planar mold having a plurality of thermally partitioned zones. The term "thermally partitioned" does not necessarily mean that the set temperatures are different, but rather that the heat sources are partitioned differently.

As an example, as shown in FIG. 2, zones H1 to H3 are heating zones, and zones C1 to C2 are cooling zones. Additionally, in the TD direction, it is an example of being thermally divided into five segments.

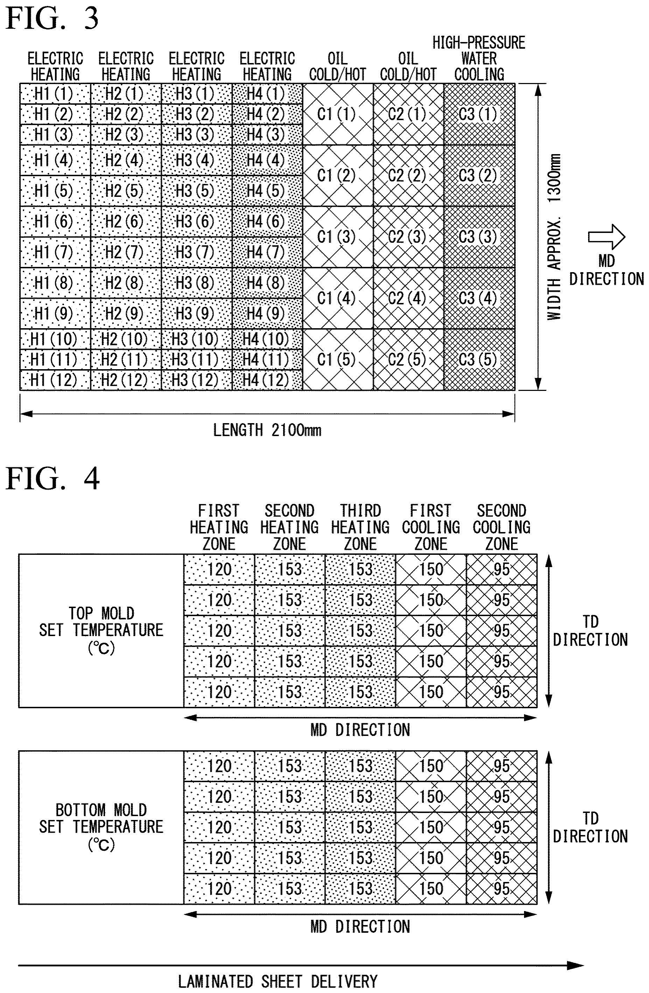

Furthermore, an example of multiple thermal zones is shown in FIG. 3.

In FIG. 3, zones H1 to H4 are heating zones, and zones C1 to C3 are cooling zones. Furthermore, the heating zone is thermally divided into four segments in the MD direction and twelve segments in the TD direction, while the cooling zone is thermally divided into three segments in the MD direction and five segments in the TD direction.

In the present invention, the number of stages in the MD direction for the heating and cooling zones can be appropriately selected depending on the size of the laminated sheet (MLS) to be manufactured, but it is preferable that the heating zone is thermally partitioned into 2 to 10 stages, preferably 2 to 6 stages, and the cooling zone is thermally partitioned into 1 stage or 2 to 5 stages in the MD direction, as this facilitates thermal control, achieves excellent in-plane rigidity homogeneity according to the desired thickness, reduces variation in mechanical properties, and enables the production of a laminated sheet with excellent surface smoothness.

Here, thermally partitioned does not only mean that the mold itself is physically divided into individual parts, but also includes a state where, even if the mold appears to be a uniformly extended planar metal plate, temperature control is performed by heaters corresponding to each zone, achieving multi-stage thermal control.

The set temperature of each heating zone can be set such that the temperature of the first heating zone closest to the sheet inlet (insertion port) of the multilayer oriented film is 110 to 160°C, the second heating zone is +10 to +40°C relative to the set temperature of the first heating zone, and subsequent zones are set at +0 to 30°C relative to the previous zone, with a maximum of 170°C being preferable. On the other hand, the set temperature of the cooling zone is preferably set at -2 to -10°C relative to the final heating zone, and if a subsequent cooling zone exists, it is preferably set at -30 to -60°C relative to the set temperature of the previous cooling zone. Additionally, the temperature of the final cooling zone is preferably 25 to 125°C, particularly preferably 60 to 125°C.

As described above, the laminated film inserted between the upper and lower molds 2 is pressed by a plurality of cylinders 6 disposed above the upper mold and pressed by the upper and lower molds 2.

The press pressure in this case is preferably 1 to 40 MPa, as described above, and during press release, the laminated sheet (MLS) is advanced by a predetermined width.

To enhance the surface smoothness of the laminated sheet (MLS), it is preferable to interpose a sheet-shaped release material between the laminated sheet and the planar mold 2. Examples of the sheet-shaped release material include paper materials, polyethylene terephthalate sheets, polycarbonate sheets, polypropylene sheets, and steel plates, among which polycarbonate sheets and steel plates are preferable from the viewpoint of further improving the surface condition of the laminated sheet.

The laminated sheet obtained in this manner maintains appropriate orientation of the polypropylene constituting each layer while ensuring sufficient interlayer fusion, resulting in a laminated sheet with high overall rigidity. As described above, it exhibits excellent in-plane strength homogeneity, minimal variation in mechanical properties, and particularly uniform strength in the TD direction when formed into a large area, demonstrating distinctive performance.

[Method 2] Sheet-Fed Press Method

Next, Method 2 is a method for manufacturing the laminated sheet (MLS) of the present invention by a sheet-fed press method, specifically including a step of placing the laminated sheet precursor (pMS) on a lower metal plate in a chamber of a sheet-fed vacuum lamination device having planar metal plates above and below in the chamber, heat-pressing while setting the chamber to a vacuum degree of 170 Pa or less, and after press release, sandwiching the sheet between cooling metal plates.

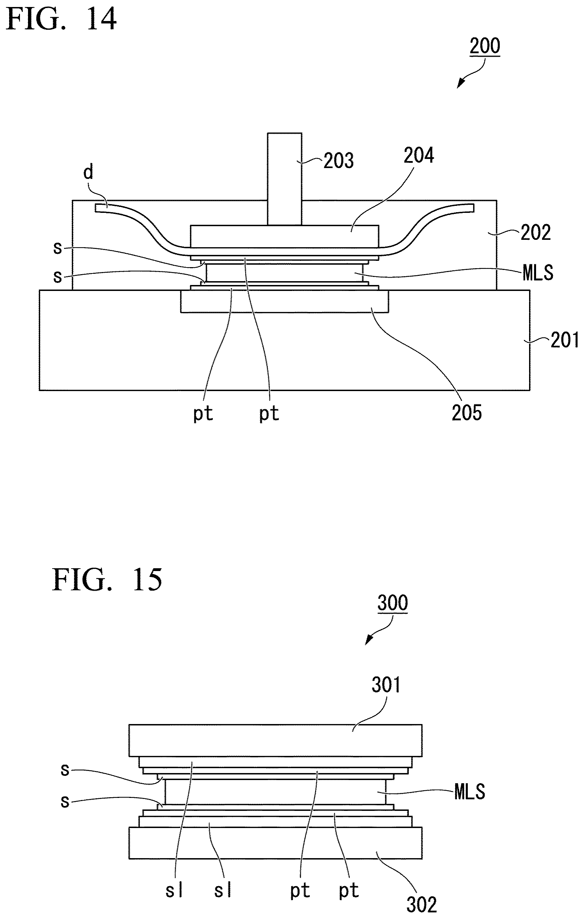

Specifically, for example, as schematically shown in FIG. 14, a film laminate formed by stacking a plurality of biaxially oriented films is placed between a pair of upper and lower heating plates (204, 205) disposed in the chamber (202) of a sheet-fed vacuum lamination device (200), then the chamber (202) is closed, the heating plates (204, 205) are heated to a predetermined temperature while reducing the internal pressure, followed by pressing with a hydraulic cylinder (203) for a predetermined time, then returning the internal pressure to atmospheric pressure while releasing the cylinder pressure to remove the laminated sheet (MLS). Subsequently, the sheet is promptly transferred to a cooling device (300) shown in FIG. 15, sandwiched between a pair of upper and lower cooling metal plates (301, 302), and cooled at room temperature.

The film laminate may be set directly in the chamber of the sheet-fed vacuum lamination device, but as shown in FIG. 14, it is preferable to subject it to heat-pressing while sandwiched between stainless steel plates (s) on its upper and lower surfaces, as this results in an excellent surface condition of the laminated sheet (MLS). The stainless steel plates (s) sandwiching the film laminate preferably have a thickness of 0.3 to 1 mm. Furthermore, as shown in FIG. 14, a diaphragm (d) may be interposed directly below the upper heating plate, and a polytetrafluoroethylene sheet (pt) may be interposed between the heating plate and the stainless steel plate (s) for the purpose of protecting the heating plate.

The heating plates of such a sheet-fed vacuum lamination device preferably have a set temperature of 140 to 155°C, and the pressure of the hydraulic cylinder is preferably 0.1 to 10 MPa.

By manufacturing using such a sheet-fed press method, it is possible to obtain a laminated sheet with even higher rigidity and strength, as well as excellent uniformity thereof.

[Laminated Sheet]

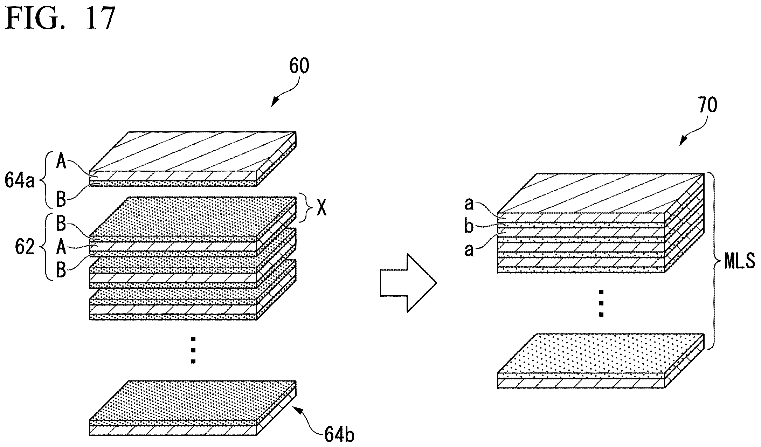

An example of the laminated sheet (MLS, 70) obtained by Method 1 or Method 2 described above in detail is, as shown in FIG. 17, a structure in which a laminated sheet precursor (pMS) (60) comprising a plurality of multilayer biaxially oriented films (X) (62, 64a, 64b) is laminated, and as a result of fusion at the B/B boundary, the fused layers are integrated to form the layer b, resulting in a structure in which the layer a and the layer b are alternately laminated.

[Molded Article]

The molded article of the present invention is formed by molding the laminated sheet (MLS) of the present invention. By molding the laminated sheet of the present embodiment, various molded articles can be obtained. Examples of molding methods include known press molding, hot plate molding, stretch molding, rolling molding, drawing molding, pressure bonding molding, fusion molding, vacuum molding, air pressure molding, and vacuum-air pressure molding.

Among these, since the present invention has the unprecedented feature of enabling industrial production of large-area laminated sheets, it is preferable to process them into various molded articles by press molding. The temperature conditions for secondary molding of the laminated sheet can be appropriately selected depending on the shape or drawing depth, but, for example, molding is possible at 100°C or higher and below the melting point of the laminated sheet (MLS). In particular, when molding into molded articles with shallow drawing, such as mobility exterior materials or residential building materials, molding can be performed at 120 to 150°C.

[Applications of the Laminated Sheet]

The laminated sheet of the present invention, as described above in detail, has excellent rigidity as a plastic material and can be widely used industrially as an alternative to aluminum, CFRP, or steel plates, for example, in automotive exterior materials, automotive interior materials, automotive structural materials, exterior materials for flying cars, building exterior wall materials, building interior materials, solar cell substrates, substrate sheets for flexible solar cells, quantum stealth optical materials, logistics drone body materials, surfboards, wind turbine blades, ship exterior wall materials, lithium-ion battery case materials, lithium-ion battery electrode substrates, hydrogen tank structural materials, food trays, and medical trays.

Among these, for example, by using the laminated sheet as a body material for automotive exteriors, recycling of the body material is possible. Furthermore, by laminating a decorative film onto the polypropylene laminated sheet of the present invention or sandwiching it between the layers of the laminated sheet, it can be used as a paintless automotive exterior material.

When using such a decorative film, for example, the surface of the B layer or C layer of the AB film, BAB film, or BAC film can be corona-treated and printed to form a decorative film.

In this case, by laminating the printed surface of the decorative film to the laminated sheet, a decorative sheet with excellent appearance can be obtained. If the printed layer is prone to peeling, the surface of the laminated sheet of the present invention can be corona-treated, and the printed surface of the decorative film can be laminated to the printed surface of the laminated sheet to adhere them together, thereby effectively preventing peeling from the printed surface.

Additionally, the hydrogen tank structural material can be used, for example, as a structural material for Type 2 or Type 4 high-pressure hydrogen tanks.

(Solar Cell Sheet)

The solar cell sheet of the present invention is formed by laminating a flexible solar cell module onto the laminated sheet of the present invention. The solar cell sheet of the present invention includes those formed by laminating a flexible solar cell module onto the surface or back surface of the laminated sheet of the present invention, or by sandwiching the flexible solar cell module between two laminated sheets of the present invention.

Examples of the flexible solar cell module include film- or sheet-shaped solar cell modules such as thin-film silicon solar cells, organic thin-film solar cells, and perovskite solar cells.

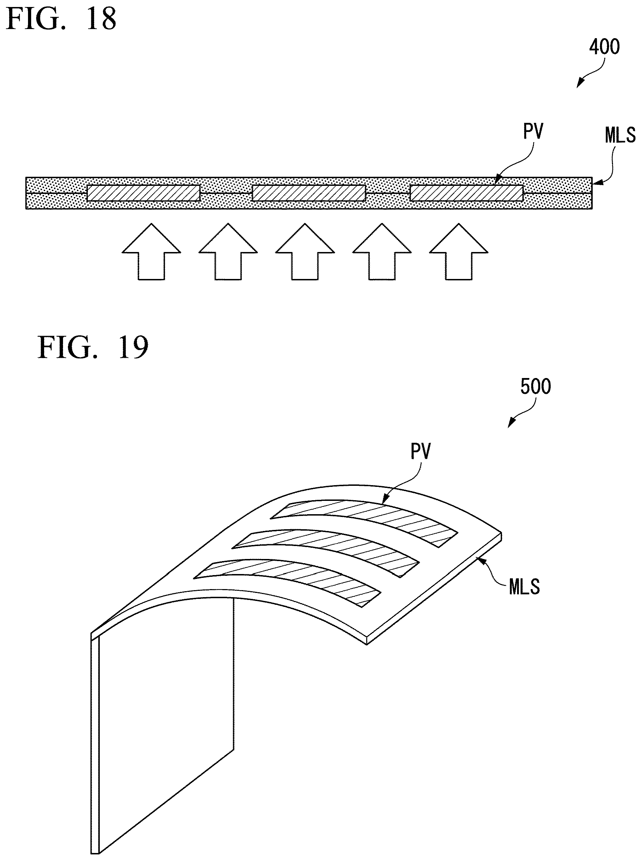

An embodiment of the solar cell sheet of the present invention is shown in FIG. 18. FIG. 18 is a cross-sectional view schematically showing the cross-section of the solar cell sheet, which has a structure in which a flexible solar cell module is sandwiched and laminated between two laminated sheets of the present invention.

The solar cell sheet of the present invention can, for example, be pre-shaped to conform to the wall surface shape, roofing material, or columnar structure shape of a building, thereby achieving aesthetic integration with the adherend, significantly improving the aesthetic appearance of the installed solar system compared to conventional panel-type silicon solar cells.

Furthermore, in this case, the high integration with the adherend, such as a building, enables stable fixation over a long period, allowing for longer-term use compared to simply attaching a film-shaped solar cell module to an existing building.

Additionally, the solar cell sheet of the present invention is preferably used as a solar cell sheet with an arch-shaped single-curved surface. Such a solar cell sheet with an arch-shaped single-curved surface can be obtained, for example, by molding the laminated sheet of the present invention into a single-curved surface with curvature in one direction and then laminating a flexible solar cell module onto the surface or back surface of the laminated sheet, or by sandwiching a flexible solar cell module between two laminated sheets molded into a single-curved surface, or by laminating a flexible solar cell module onto the laminated sheet of the present invention and then bending it in one direction to fix it to the adherend. Such a solar cell sheet with an arch-shaped single-curved surface can receive sunlight more directly for a longer time, thereby increasing power generation.

The solar cell sheet of the present invention may also be three-dimensionally molded. For example, by three-dimensionally molding a solar cell sheet in which a flexible solar cell module is laminated onto the surface or back surface of the laminated sheet of the present invention, or, as shown in FIG. 18, a solar cell sheet in which a flexible solar cell module is sandwiched and laminated between two laminated sheets of the present invention, a solar cell sheet with a desired shape can be obtained.

Additionally, the laminated sheet constituting the solar cell sheet of the present invention has a water vapor transmission coefficient of 0.10 to 0.13 cc·mm/m$^2$·25h/atm, which is lower than other materials, so by applying a barrier coating to the outermost surface as needed, the laminated sheet can function as a barrier substrate, achieving durability and long-term reliability as a solar cell.

Furthermore, by providing a linear groove structure on the laminated sheet constituting the solar cell sheet of the present invention, the rigidity and strength of the sheet itself can be significantly enhanced.

Next, the flexible solar cell constituting the solar cell sheet of the present invention is preferably a perovskite solar cell. Perovskite solar cells are lightweight, highly flexible, and resistant to strain, making them applicable to various structures. Additionally, they can generate power even in low-light conditions and have fewer installation constraints, such as not requiring consideration of sunny locations or orientations. However, due to their flexibility, they are less workable when installed on building walls or roofs, and simply adhering them to a wall surface with adhesive may lead to issues such as easy detachment during strong winds like typhoons or disasters like earthquakes, posing a challenge in stably fixing lightweight film-shaped solar cells, which are not limited by installation location, to adherend structures over the long term.

Therefore, by using the laminated sheet of the present invention as a support sheet for perovskite solar cell films, stable fixation to buildings and the like can be achieved over the long term.

Here, methods for fixing the solar cell sheet of the present invention to buildings or the like include, for example, shaping the sheet ends to a predetermined shape and fixing them to the structure by fitting engagement, fixing by bolting, fixing with sealing materials, and adhering and fixing to the adherend with adhesive.

Additionally, a method of using the laminated sheet itself as a structural material, such as exterior wall material or roofing material, is also included. An example of using the laminated sheet as a solar cell integrated carport is shown in FIG.

19.

Here, methods for manufacturing the solar cell sheet of the present invention using a film-shaped perovskite solar cell include the following:

1. A method of shaping the laminated sheet, as needed, to conform to the shape of the adherend structure or a desired shape, and then laminating a perovskite solar cell film onto the surface or back surface of the shaped article.

2. A method of laminating a perovskite solar cell film onto the surface or back surface of the laminated sheet and then shaping it to a predetermined shape.

3. A method of preparing two laminated sheets shaped, as needed, to conform to the shape of the adherend structure or a desired substantially identical shape, and then sandwiching a perovskite solar cell film from the top and bottom surfaces with these shaped articles.

4. A method of laminating the laminated sheet onto the top and bottom surfaces of a perovskite solar cell film and then shaping it to a predetermined shape.

5. A method of sandwiching a perovskite solar cell film between the layers of the precursor (pMS) and heat-fusing it to form a perovskite solar cell sheet with the perovskite solar cell film embedded, followed by shaping by press molding or the like.

Among these, when the solar cell sheet of the present invention is manufactured by Method 5, the solar cell is completely embedded within the laminated sheet, completely shielding it from moisture or water, thereby effectively preventing degradation due to moisture.

The solar cell molded article obtained in this manner can be used for automotive roof materials, solar carports, balcony parapets, residential roofing materials, and the like.

EXAMPLES

Hereinafter, the present invention will be described in detail with reference to examples, but the present invention is not limited thereto.

(Raw Material Preparation)

Using the following polypropylene A1 (melting point: 163°C, MFR: 4 g/10 min, ethylene content: 0.2 mass%, Mw/Mn = 9, xylene-insoluble fraction content: 98.2 mass%, mmmm = 98.3, nucleating agent content: 0.05 mass%, t1/2: 2.3 seconds) and the following ethylene-propylene random copolymer B1 (melting point: 153°C, MFR: 5 g/10 min) or ethylene-propylene random copolymer B2 (melting point: 137°C, MFR: 7.5 g/10 min), a co-extruded sheet with the following layer configuration was obtained using a T-die molding machine, and then stretched to a predetermined stretch ratio using a biaxial stretching device to obtain a biaxially oriented film.

[BAB Co-extruded Film 1]

A two-type three-layer co-extruded film with a layer configuration of B/A/B (thickness: 50 μm, B/A/B thickness ratio: 5/90/5, stretch ratio: 5 × 9 times)

A: Polypropylene A1
B: Ethylene-propylene random copolymer B1

[BAB Co-extruded Film 2]

A two-type three-layer co-extruded film with a layer configuration of B/A/B (thickness: 200 μm, B/A/B thickness ratio: 5/90/5, stretch ratio: 3.5 × 3.5 times)

A: Polypropylene A1
B: Ethylene-propylene random copolymer B2

[BAA Co-extruded Film 1]

A two-type three-layer co-extruded film with a layer configuration of B/A/A (thickness: 50 μm, B/A/A thickness ratio: 5/90/5, stretch ratio: 5 × 9 times)

A: Polypropylene A1
B: Ethylene-propylene random copolymer B1

[BAA Co-extruded Film 2]

A two-type three-layer co-extruded film with a layer configuration of B/A/A (thickness: 50 μm, B/A/A thickness ratio: 5/90/5, stretch ratio: 3.5 × 3.5 times)

A: Polypropylene A1
B: Ethylene-propylene random copolymer B2

(Evaluation)

<Tensile Test>

In accordance with JIS K7161, the tensile modulus of elasticity was measured in the x-direction and y-direction at positions (1), (2), and (3) shown in FIGS. 5, 6, or 12. In Example 4, the MD direction of the raw material film was denoted as the x-direction.
Equipment used: AUTOGRAPH AG-x plus (manufactured by Shimadzu Corporation)

- Test piece: Dumbbell-shaped test piece shown in FIG. 7(a) (Dumbbell No. 1 type)
- Distance between chucks: 100 mm
- Test speed: 1 mm/min
- Stroke: 1 mm
- Elastic modulus calculation method: Slope between two points at strokes of 0.05 mm and 0.25 mm
- Plot collection start point: 3 N

<Flexural Test>

In accordance with JIS K7171, the flexural modulus of elasticity was measured in the TD direction (y-direction) and MD direction (x-direction) at positions (1), (2), and (3) shown in FIG. 5. In Example 4, the MD direction of the raw material film was denoted as the x-direction.
Equipment used: AUTOGRAPH AG-x plus (manufactured by Shimadzu Corporation)

- Test piece: Strip-shaped test piece of 150 × 25 mm shown in FIG. 7(b)
- Distance between lower support points: 47 mm
- Test speed: 1.26 mm/min
- Stroke: 1 mm
- Elastic modulus calculation method: Slope between two points at strokes of 0.05 mm and 0.25 mm
- Plot collection start point: 3 N

<Surface Condition Evaluation>

Test pieces for surface condition evaluation were cut out from positions α, β, and γ shown in FIGS. 8, 9, or 13. The size of the test piece is shown in FIG. 10.
The method for determining the positions α, β, and γ and the method for collecting each test piece are the same as those described in the (laminated sheet) section above.
In accordance with JIS B 0601:2001, the arithmetic surface roughness (Ra) was measured under the following conditions:

- Equipment used: Surftest SJ-400 (manufactured by Mitutoyo Corporation)
- Test speed: 1 mm/min
- Filter: GAUSS
- λc (waviness cutoff parameter): 8 mm
- λs (noise cutoff parameter): 25 μm
- Measurement speed: 1 mm/s
- Evaluation length: 16.0 mm
- Stylus tip radius: 2 μm

- Stylus tip angle: 60°

The test piece size and measurement positions are shown in FIG. 10.

(Example 1)

As a preparation step, 48 sheets of the BAB co-extruded film 1 were stacked, and BAA film 1 was laminated on both surfaces such that the A layer is on the surface to obtain a precursor (pMS1). This was then inserted into a pressing device with a continuous compression molding mechanism shown in FIG. 1, and pressing, pressure release, and advancement of the laminated sheet were repeated continuously.

The temperature settings of the upper and lower molds in the pressing device were as shown in FIG. 4, with a pressure of 30 MPa for four cylinders, a press time of 5 seconds, and a sheet advancement length of 25 mm during pressure release.

In this manner, a transparent laminated sheet (MLS) with dimensions of 595 × 1500 mm and a thickness of 2.5 mm, as shown in FIG. 5, was obtained.

From the obtained transparent laminated sheet, dumbbell-shaped test pieces for tensile testing and strip-shaped test pieces for flexural testing were cut out from the positions shown in FIG. 5, and mechanical properties were evaluated using the measurement methods described in <Tensile Test> and <Flexural Test> above. The results are shown in Table 1.

Additionally, test pieces for surface condition evaluation were cut out from the positions shown in FIG. 8 from the obtained laminated sheet, and the surface condition was evaluated using the measurement method described in <Surface Condition Evaluation> above. The results are shown in Table 2.

(Example 2)

A precursor (pMS2) was obtained in the same manner as in Example 1, except that BAB film 1 and BAA film 1 with a width of 700 mm were used.

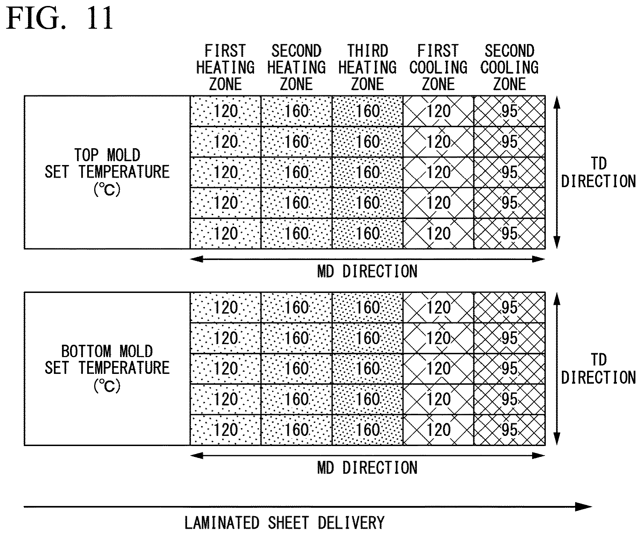

Then, lamination was performed in the same manner as in Example 1, except that the temperature settings of the upper and lower molds in the pressing device were as shown in FIG. 11.

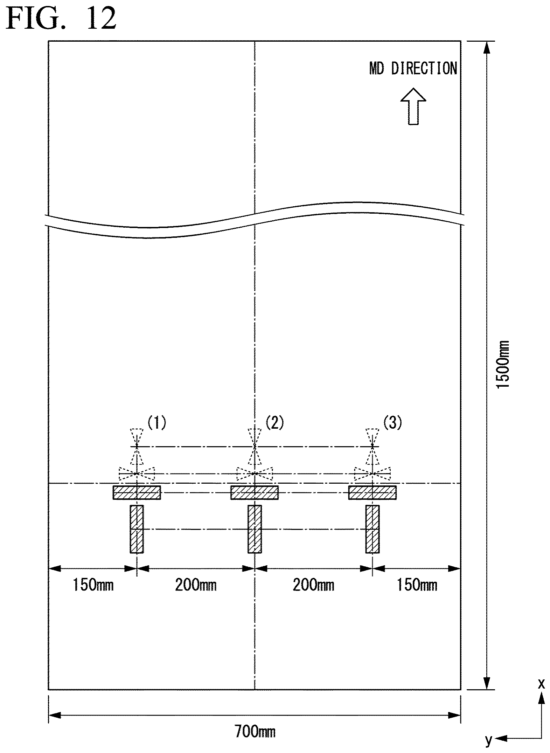

In this manner, a transparent laminated sheet with dimensions of 700 × 1500 mm and a thickness of 2.5 mm, as shown in FIG. 12, was obtained.

From the obtained transparent laminated sheet (MLS), dumbbell-shaped test pieces for tensile testing and strip-shaped test pieces for flexural testing were cut out from the positions shown in FIG. 12, and mechanical properties were evaluated using the measurement methods described in <Tensile Test> and <Flexural Test> above. The results are shown in Table 1.

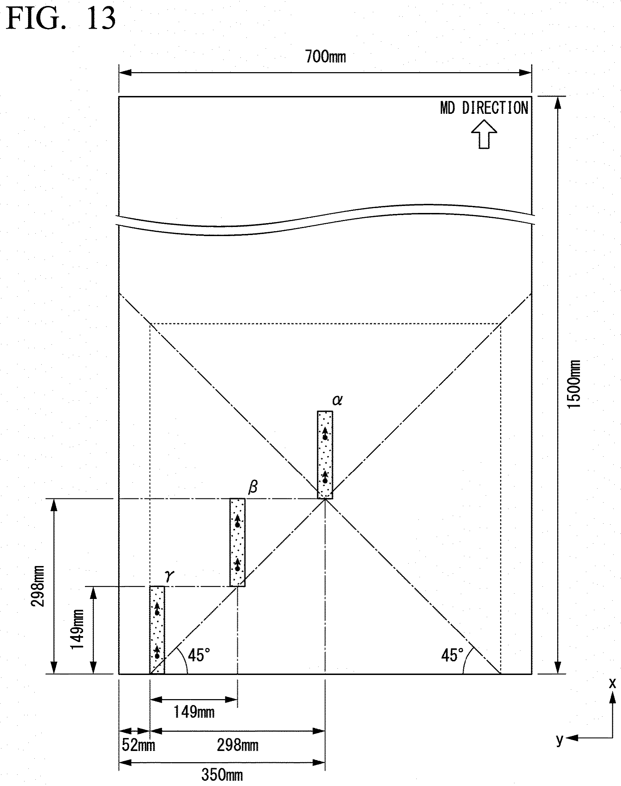

Additionally, test pieces for surface condition evaluation were cut out from the positions shown in FIG. 13 from the obtained laminated sheet, and the surface condition was evaluated using the measurement method described in <Surface Condition Evaluation> above. The results are shown in Table 2.

(Example 3)

A precursor (pMS3) was obtained in the same manner as in Example 1, except that as a preparation step, 15 sheets of BAB co-extruded film 2 were stacked, and BAA film 2 (thickness: 200 $\mu$m) was laminated on both surfaces such that the A layer is on the surface.

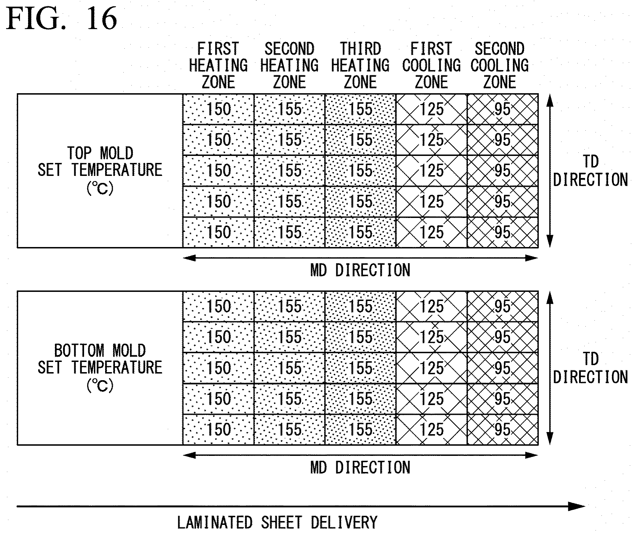

Then, lamination was performed in the same manner as in Example 1, except that the temperature settings of the upper and lower molds in the pressing device were as shown in FIG. 16, to obtain a transparent laminated sheet with dimensions of 700 × 1500 mm and a thickness of 3 mm.

From the obtained transparent laminated sheet, dumbbell-shaped test pieces for tensile testing and strip-shaped test pieces for flexural testing were cut out from the positions shown in FIG. 12, and mechanical properties were evaluated using the measurement methods described in <Tensile Test> and <Flexural Test> above. The results are shown in Table 1.

(Example 4)

40 sheets of BAB co-extruded film 1 were stacked, and BAA film 1 was laminated on both surfaces such that the A layer is on the surface, and cut to a size of 700 × 700 mm. Here, the B/A/B co-extruded film and B/A co-extruded film were stacked such that the MD direction and TD direction were aligned.

Lamination was performed using the chamber of the sheet-fed vacuum lamination device shown in FIG. 14 and the cooling device shown in FIG. 15. The lamination conditions were as follows:

- Upper heating plate temperature: 150°C
- Lower heating plate temperature: 145°C
- Vacuum evacuation time: 120 seconds
- Pressing time: 300 seconds
- Holding time: 300 seconds
- Heating plate press time: 300 seconds
- Heating plate press pressure: 0.3 MPa

Configuration during lamination pressing:

From top: Polytetrafluoroethylene sheet/SUS plate/laminated sheet/SUS plate/Polytetrafluoroethylene sheet
From the obtained transparent laminated sheet, dumbbell-shaped test pieces for tensile testing and strip-shaped test pieces for flexural testing were cut out from the positions shown in FIG. 6, and mechanical properties were evaluated using the measurement methods described in <Tensile Test> and <Flexural Test> above. Here, evaluations were performed with the MD direction of the raw material films denoted as the x-direction and the TD direction denoted as the y-direction. The results are shown in Table 1.

Additionally, test pieces for surface condition evaluation were cut out from the positions shown in FIG. 9 from the obtained laminated sheet, and the surface condition was evaluated using the measurement method described in <Surface Condition Evaluation> above. The results are shown in Table 2.

(Comparative Example 1)

Using the same configuration as in Example 1, a precursor (pMS1) cut to 400 × 400 mm was attempted to be laminated using a roll molding machine (induction heating jacket roller manufactured by Tokuden Co., Ltd., model "JR-D0-W," roll diameter: φ200 mm × 2, roll surface length: 400 mm).

- Heating roll temperature: 165°C
- Heating roll molding take-up speed: 0.8 m/min
- Preheating roll: 130 to 155°C

However, the obtained laminated sheet had dispersed areas that are not bonded due to incorporation of air throughout the sheet, and exhibited warping and waviness. Additionally, even when the heating roll molding take-up speed was reduced and lamination was attempted again, wrinkles formed on the surface layer due to the radiant heat from the heating roll, and a smooth laminated sheet could not be obtained.

[Table 1]

| | x/y | Sampling Position | Tensile Modulus of Elasticity | Average | Standard Deviation | Coefficient of Variation | Flexural Modulus of Elasticity | Average | Standard Deviation | Coefficient of Variation |
|---|---|---|---|---|---|---|---|---|---|---|
| Example 1 | x | (1) | 2646 | 2540 | 109 | 4.3% | 2363 | 2490 | 115 | 4.6% |
| | | (2) | 2552 | | | | 2502 | | | |
| | | (3) | 2430 | | | | 2591 | | | |
| | y | (1) | 3499 | 3450 | 63 | 1.8% | 4612 | 4680 | 131 | 2.8% |
| | | (2) | 3467 | | | | 4831 | | | |
| | | (3) | 3377 | | | | 4596 | | | |
| Example 2 | x | (1) | 2510 | 2530 | 43 | 1.7% | 2697 | 2630 | 69 | 2.6% |
| | | (2) | 2577 | | | | 2623 | | | |
| | | (3) | 2497 | | | | 2560 | | | |
| | y | (1) | 3364 | 3340 | 30 | 0.9% | 4844 | 4880 | 75 | 1.5% |
| | | (2) | 3356 | | | | 4972 | | | |
| | | (3) | 3308 | | | | 4838 | | | |
| Example 3 | x | (1) | 2365 | 2450 | 63 | 2.6% | 2680 | 2550 | 129 | 5.0% |
| | | (2) | 2479 | | | | 2423 | | | |
| | | (3) | 2471 | | | | 2545 | | | |
| | y | (1) | 2407 | 2400 | 36 | 1.5% | 2834 | 2800 | 27 | 1.0% |
| | | (2) | 2381 | | | | 2838 | | | |
| | | (3) | 2453 | | | | 2789 | | | |
| Example 4 | x | (1) | 2652 | 2640 | 15 | 0.6% | 2948 | 2870 | 89 | 3.1% |
| | | (2) | 2642 | | | | 2773 | | | |
| | | (3) | 2622 | | | | 2887 | | | |
| | y | (1) | 3927 | 3920 | 78 | 2.0% | 5308 | 5240 | 71 | 1.4% |
| | | (2) | 3990 | | | | 5236 | | | |
| | | (3) | 3834 | | | | 5167 | | | |

[Table 2]

| Sample | Sampling Position | Test Position | Ra/μm | ΔRa/μm | Relative Roughness ΔRa% | Average ΔRa% |
|---|---|---|---|---|---|---|
| Example 1 | γ | 1 | 0.41 | 0.16 | 64% | 46% |
| | | 2 | 0.4 | 0.15 | 60% | |
| | β | 1 | 0.48 | 0.23 | 92% | |
| | | 2 | 0.24 | 0.01 | 4% | |
| | α | 1 | 0.25 | Reference | - | |
| | | 2 | 0.22 | 0.03 | 12% | |
| Example 2 | γ | 1 | 0.6 | 0.1 | 20% | 24% |
| | | 2 | 0.56 | 0.06 | 12% | |
| | β | 1 | 0.37 | 0.13 | 26% | |
| | | 2 | 0.67 | 0.17 | 34% | |
| | α | 1 | 0.5 | Reference | - | |
| | | 2 | 0.63 | 0.13 | 26% | |
| Example 4 | γ | 1 | 0.72 | 0.39 | 118% | 260% |
| | | 2 | 1.41 | 1.08 | 327% | |
| | β | 1 | 1.21 | 0.88 | 267% | |
| | | 2 | 2.18 | 1.85 | 561% | |
| | α | 1 | 0.33 | Reference | - | |
| | | 2 | 0.42 | 0.09 | 27% | |

REFERENCE SIGNS LIST

2: Mold
4: Heating/Cooling Plate Module
6: Hydraulic Cylinder
8: Lifting Unit
10: Lifting Guide
12: Pull-Out Unit
20: Product Travel Direction
60: Laminated Sheet Precursor (pMS)
62: Multilayer Biaxially Oriented Film (X)
64a: Multilayer Biaxially Oriented Film (X)
64b: Multilayer Biaxially Oriented Film (X)
100: Continuous Pressing Device
200: Sheet-Fed Vacuum Lamination Device
201: Device Body
202: Chamber
203: Hydraulic Cylinder
204: Heating Plate
205: Heating Plate
300: Cooling Device
301: Cooling Metal Plate
302: Cooling Metal Plate
d: Diaphragm
s: Stainless Steel Plate
sl: Silicone Sheet
pt: Polytetrafluoroethylene Sheet

MLS, 70: Laminated Sheet
PV: Flexible Solar Cell Module
400: Solar Cell Sheet
500: Solar Cell Integrated Carport

## Claims

1. A laminated sheet having a structure in which layer a, comprising a biaxially oriented polypropylene film, and layer b, comprising an olefin-based resin with a melting point of 110 to 160°C, are alternately laminated, wherein, when one side direction of the laminated sheet is denoted as an x-direction and a direction perpendicular thereto is denoted as a y-direction, a tensile modulus of elasticity in both the x-direction and the y-direction at three positions-namely, a center position in the y-direction, and two positions located 200 mm from this center position in the y-direction-are all within a range of 2000 to 5000 MPa.

2. The laminated sheet according to claim 1, wherein, in a plan view of the laminated sheet, when a 595 mm $\times$ 595 mm square is drawn such that an intersection of diagonals corresponds to the center position in the y-direction, the intersection of the diagonals is denoted as $\alpha$, a midpoint between the intersection and a corner along the diagonal is denoted as $\beta$, and the corner is denoted as $\gamma$, and

   when a surface roughness at positions $\alpha$, $\beta$, and $\gamma$ is denoted as Ra($\alpha$), Ra($\beta$), and Ra($\gamma$), respectively, Ra($\alpha$), Ra($\beta$), and Ra($\gamma$) satisfy the following expressions (1) and (2):

   $$\mathrm{Ra}(\alpha) - \mathrm{Ra}(\beta) < 0.3 \quad (1)$$

   $$\mathrm{Ra}(\alpha) - \mathrm{Ra}(\gamma) < 0.3 \quad (2)$$

   wherein Ra($\alpha$), Ra($\beta$), and Ra($\gamma$) are average values (average roughness) of surface roughness measured at two locations on each of test piece $\alpha$, test piece $\beta$, and test piece $\gamma$, respectively, which are strip-shaped test pieces cut out with the x-direction as a long side from positions $\alpha$, $\beta$, and $\gamma$.

3. The laminated sheet according to claim 1 or 2, wherein the laminated sheet is formed by stacking and heat-fusing a plurality of multilayer biaxially oriented films (X), each comprising a biaxially oriented polypropylene film (A) constituting the layer a and a biaxially oriented olefin-based resin film (B) constituting the layer b laminated on at least one surface of the film (A), and the multilayer biaxially oriented film (X) has a stretch ratio in an MD direction of 2.8 to 8 times and a stretch ratio in a TD direction of 2.8 to 12 times.

4. The laminated sheet according to claim 3, wherein the multilayer biaxially oriented film (X) is a BAB-type film comprising the biaxially oriented olefin-based resin film (B) on both surfaces of the biaxially oriented polypropylene film (A), and has a thickness of 30 to 80 $\mu$m, and the laminated sheet is formed by laminating 30 to 60 sheets of the BAB-type film, with a BA-type film or a BAA-type film laminated on both surfaces such that the A layer is on the surface.

5. The laminated sheet according to claim 4, wherein the multilayer biaxially oriented film (X) is a BAB-type film comprising the biaxially oriented olefin-based resin film (B) on both surfaces of the biaxially oriented polypropylene film (A), and has a thickness of 100 to 400 $\mu$m, and the laminated sheet is formed by laminating 2 to 20 sheets of the BAB-type film, with a BA-type film or a BAA-type film laminated on both surfaces such that the A layer is on the surface.

6. A sheet molded article of the laminated sheet according to claim 1 or 2.

7. A method for producing a laminated sheet having a structure in which layer a, comprising a biaxially oriented polypropylene film, and layer b, comprising an olefin-based resin with a melting point of 110 to 160°C, are alternately laminated, the method comprising:

   a preparation step of stacking a plurality of multilayer biaxially oriented films (X), each comprising a biaxially oriented polypropylene film (A) constituting the layer a and a biaxially oriented olefin-based resin film (B) constituting the layer b laminated on at least one surface of the film (A), to form a laminated sheet precursor (pMS); and

a press step of heat-pressing the laminated sheet precursor (pMS) on a planar surface.

8. A method for producing a laminated sheet having a structure in which layer a, comprising a biaxially oriented polypropylene film, and layer b, comprising an olefin-based resin with a melting point of 110 to 160°C, are alternately laminated, the method comprising:

a preparation step of stacking a plurality of multilayer biaxially oriented films (X), each comprising a biaxially oriented polypropylene film (A) constituting the layer a and a biaxially oriented olefin-based resin film (B) constituting the layer b laminated on at least one surface of the film (A), to form a laminated sheet precursor (pMS); and

a press step of continuously heat-pressing the laminated sheet precursor (pMS) using a continuous pressing device, followed by cooling,

wherein the continuous pressing device has multiple heating zones and a cooling zone, and in the heating zone, the laminated sheet precursor (pMS) is heat-pressed with upper and lower planar molds, followed by continuous pressing in the cooling zone with upper and lower planar molds.

9. The method for producing a laminated sheet according to claim 8, wherein the laminated sheet precursor (pMS) is inserted between upper and lower planar molds constituting the heating zone of the continuous pressing device, pressed under conditions of 110 to 170°C and a pressure of 1 to 40 MPa, then, after press release, the sheet is advanced a predetermined length in a travel direction (MD direction), heat-pressed again, and this process is repeated to continuously transfer the sheet from the heating zone to the cooling zone, followed by pressing in the cooling zone under conditions of 25 to 125°C and a pressure of 1 to 40 MPa, and, after press release, the sheet is advanced in the predetermined travel direction to continuously extract the heat-fused laminated sheet.

10. The method for producing a laminated sheet according to claim 9, wherein the heating zone is divided into 2 to 10 stages in the MD direction, composed of molds with planar contact surfaces that sandwich the sheet from above and below, and

the cooling zone is divided into 1 or 2 to 5 stages in the MD direction, composed of molds with planar contact surfaces that sandwich the sheet from above and below.

11. The method for producing a laminated sheet according to claim 9 or 10, wherein temperature conditions of the heating zone, divided into 2 to 10 stages in the MD direction, are such that a temperature of a first heating zone closest to a sheet inlet is 110 to 160°C, a temperature of a second heating zone following it is +10 to +40°C relative to a set temperature of the first heating zone, and a maximum temperature of the heating zone is 170°C.

12. The method for producing a laminated sheet according to claim 7 or 8, wherein the multilayer biaxially oriented film (X) has a stretch ratio in a MD direction of 2.8 to 8 times and a stretch ratio in a TD direction of 2.5 to 12 times.

13. The method for producing a laminated sheet according to claim 12, wherein the multilayer biaxially oriented film (X) is a BAB-type film in which the biaxially oriented olefin-based resin film (B) is laminated on both surfaces of the biaxially oriented polypropylene film (A),

a thickness of the biaxially oriented polypropylene film (A) is 30 to 80 $\mu$m, and

the laminated sheet precursor (pMS) is formed by laminating 30 to 60 sheets of the BAB-type film, with a BA-type film or a BAA-type film laminated on both surfaces such that the A layer is on the surface.

14. The method for producing a laminated sheet according to claim 7, wherein a sheet-fed vacuum lamination device having planar metal plates above and below within a chamber is used, the laminated sheet precursor (pMS) is placed on a lower metal plate in the chamber, the chamber is set to a vacuum degree of 170 Pa or less, heat-pressed, and, after press release, the sheet is sandwiched between cooling metal plates.

15. The method for producing a laminated sheet according to claim 14, wherein the heat-pressing is performed under conditions of a metal plate temperature of 140 to 160°C and a cylinder pressure of 0.1 to 1 MPa.

16. A solar cell sheet formed by laminating a flexible solar cell module onto the laminated sheet according to claim 1 or 2.

FIG. 1

FIG. 2

| ELECTRIC HEATING | ELECTRIC HEATING | ELECTRIC HEATING | OIL COLD/HOT | WATER COOLING |
|---|---|---|---|---|
| H1 (1) | H2 (1) | H3 (1) | C1 (1) | C2 (1) |
| H1 (2) | H2 (2) | H3 (2) | C1 (2) | C2 (2) |
| H1 (3) | H2 (3) | H3 (3) | C1 (3) | C2 (3) |
| H1 (4) | H2 (4) | H3 (4) | C1 (4) | C2 (4) |
| H1 (5) | H2 (5) | H3 (5) | C1 (5) | C2 (5) |

WIDTH APPROX. 600mm

MD DIRECTION

LENGTH 1000mm

## FIG. 3

| ELECTRIC HEATING | ELECTRIC HEATING | ELECTRIC HEATING | ELECTRIC HEATING | OIL COLD/HOT | OIL COLD/HOT | HIGH-PRESSURE WATER COOLING |
|---|---|---|---|---|---|---|
| H1 (1) | H2 (1) | H3 (1) | H4 (1) | | | |
| H1 (2) | H2 (2) | H3 (2) | H4 (2) | C1 (1) | C2 (1) | C3 (1) |
| H1 (3) | H2 (3) | H3 (3) | H4 (3) | | | |
| H1 (4) | H2 (4) | H3 (4) | H4 (4) | C1 (2) | C2 (2) | C3 (2) |
| H1 (5) | H2 (5) | H3 (5) | H4 (5) | | | |
| H1 (6) | H2 (6) | H3 (6) | H4 (6) | C1 (3) | C2 (3) | C3 (3) |
| H1 (7) | H2 (7) | H3 (7) | H4 (7) | | | |
| H1 (8) | H2 (8) | H3 (8) | H4 (8) | C1 (4) | C2 (4) | C3 (4) |
| H1 (9) | H2 (9) | H3 (9) | H4 (9) | | | |
| H1 (10) | H2 (10) | H3 (10) | H4 (10) | | | |
| H1 (11) | H2 (11) | H3 (11) | H4 (11) | C1 (5) | C2 (5) | C3 (5) |
| H1 (12) | H2 (12) | H3 (12) | H4 (12) | | | |

WIDTH APPROX. 1300mm

MD DIRECTION

LENGTH 2100mm

## FIG. 4

| | FIRST HEATING ZONE | SECOND HEATING ZONE | THIRD HEATING ZONE | FIRST COOLING ZONE | SECOND COOLING ZONE |
|---|---|---|---|---|---|
| TOP MOLD SET TEMPERATURE (°C) | 120 | 153 | 153 | 150 | 95 |
| | 120 | 153 | 153 | 150 | 95 |
| | 120 | 153 | 153 | 150 | 95 |
| | 120 | 153 | 153 | 150 | 95 |
| | 120 | 153 | 153 | 150 | 95 |

MD DIRECTION

TD DIRECTION

| | FIRST HEATING ZONE | SECOND HEATING ZONE | THIRD HEATING ZONE | FIRST COOLING ZONE | SECOND COOLING ZONE |
|---|---|---|---|---|---|
| BOTTOM MOLD SET TEMPERATURE (°C) | 120 | 153 | 153 | 150 | 95 |
| | 120 | 153 | 153 | 150 | 95 |
| | 120 | 153 | 153 | 150 | 95 |
| | 120 | 153 | 153 | 150 | 95 |
| | 120 | 153 | 153 | 150 | 95 |

MD DIRECTION

TD DIRECTION

LAMINATED SHEET DELIVERY

FIG. 5

## FIG. 6

MD DIRECTION

(1)  (2)  (3)

350mm

700mm

150mm  200mm  200mm  150mm

700mm

x

y

## FIG. 7

(25mm)  40mm  40mm

(a)

25mm

R25

R21

7.5mm
10mm
7.5mm

120mm

(b)

25mm

150mm

FIG. 8

FIG. 9

FIG. 10

# FIG. 11

| | FIRST HEATING ZONE | SECOND HEATING ZONE | THIRD HEATING ZONE | FIRST COOLING ZONE | SECOND COOLING ZONE | |
|---|---|---|---|---|---|---|
| TOP MOLD SET TEMPERATURE (°C) | 120 | 160 | 160 | 120 | 95 | TD DIRECTION |
| | 120 | 160 | 160 | 120 | 95 | |
| | 120 | 160 | 160 | 120 | 95 | |
| | 120 | 160 | 160 | 120 | 95 | |
| | 120 | 160 | 160 | 120 | 95 | |

MD DIRECTION

| | FIRST HEATING ZONE | SECOND HEATING ZONE | THIRD HEATING ZONE | FIRST COOLING ZONE | SECOND COOLING ZONE | |
|---|---|---|---|---|---|---|
| BOTTOM MOLD SET TEMPERATURE (°C) | 120 | 160 | 160 | 120 | 95 | TD DIRECTION |
| | 120 | 160 | 160 | 120 | 95 | |
| | 120 | 160 | 160 | 120 | 95 | |
| | 120 | 160 | 160 | 120 | 95 | |
| | 120 | 160 | 160 | 120 | 95 | |

MD DIRECTION

LAMINATED SHEET DELIVERY

FIG. 12

MD DIRECTION

(1)    (2)    (3)

1500mm

150mm    200mm    200mm    150mm

700mm

x

y

FIG. 13

## FIG. 14

## FIG. 15

# FIG. 16

| | FIRST HEATING ZONE | SECOND HEATING ZONE | THIRD HEATING ZONE | FIRST COOLING ZONE | SECOND COOLING ZONE | |
|---|---|---|---|---|---|---|
| TOP MOLD SET TEMPERATURE (°C) | 150 | 155 | 155 | 125 | 95 | TD DIRECTION |
| | 150 | 155 | 155 | 125 | 95 | |
| | 150 | 155 | 155 | 125 | 95 | |
| | 150 | 155 | 155 | 125 | 95 | |
| | 150 | 155 | 155 | 125 | 95 | |

MD DIRECTION

| | FIRST HEATING ZONE | SECOND HEATING ZONE | THIRD HEATING ZONE | FIRST COOLING ZONE | SECOND COOLING ZONE | |
|---|---|---|---|---|---|---|
| BOTTOM MOLD SET TEMPERATURE (°C) | 150 | 155 | 155 | 125 | 95 | TD DIRECTION |
| | 150 | 155 | 155 | 125 | 95 | |
| | 150 | 155 | 155 | 125 | 95 | |
| | 150 | 155 | 155 | 125 | 95 | |
| | 150 | 155 | 155 | 125 | 95 | |

MD DIRECTION

LAMINATED SHEET DELIVERY

FIG. 17

FIG. 18

FIG. 19

## INTERNATIONAL SEARCH REPORT

| International application No. |
| --- |
| **PCT/JP2024/011467** |

**A.    CLASSIFICATION OF SUBJECT MATTER**

*B32B 27/32*(2006.01)i; *B29C 43/14*(2006.01)i; *B29C 43/30*(2006.01)i; *B32B 7/022*(2019.01)i; *B32B 37/10*(2006.01)i
FI:    B32B27/32 E; B32B7/022; B32B37/10; B29C43/30; B29C43/14

According to International Patent Classification (IPC) or to both national classification and IPC

**B.    FIELDS SEARCHED**

Minimum documentation searched (classification system followed by classification symbols)

B32B1/00-43/00; B29C43/00-43/58; B29C65/00-65/82

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C.    DOCUMENTS CONSIDERED TO BE RELEVANT**

| Category* | Citation of document, with indication, where appropriate, of the relevant passages | Relevant to claim No. |
| --- | --- | --- |
| X | WO 2020/075755 A1 (SUNALLOMER LTD.) 16 April 2020 (2020-04-16)    claims 1-2, paragraphs [0013]-[0015], [0017]-[0018], [0027]-[0028], [0033], [0054], [0071], examples | 1-7, 12-16 |
| Y |  | 8-11 |
| Y | JP 2014-505607 A (LG HAUSYS, LTD.) 06 March 2014 (2014-03-06)    claim 1, paragraphs [0015], [0022]-[0023], fig. 1 | 8-11 |
| A | JP 2017-001371 A (MITSUBISHI RAYON CO.) 05 January 2017 (2017-01-05)    entire text, all drawings | 1-16 |
| A | WO 2022/102706 A1 (FP CORPORATION) 19 May 2022 (2022-05-19)    entire text, all drawings | 1-16 |
| A | WO 2022/102705 A1 (FP CORPORATION) 19 May 2022 (2022-05-19)    entire text, all drawings | 1-16 |

☐ Further documents are listed in the continuation of Box C.          ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **04 June 2024** | **18 June 2024** |

| Name and mailing address of the ISA/JP | Authorized officer |
| --- | --- |
| **Japan Patent Office (ISA/JP)**  **3-4-3 Kasumigaseki, Chiyoda-ku, Tokyo 100-8915**  **Japan** |  |
| | Telephone No. |

Form PCT/ISA/210 (second sheet) (July 2022)

EP 4 684 963 A1

## INTERNATIONAL SEARCH REPORT
### Information on patent family members

International application No.

**PCT/JP2024/011467**

| Patent document cited in search report | | | Publication date (day/month/year) | Patent family member(s) | | | Publication date (day/month/year) |
|---|---|---|---|---|---|---|---|
| WO | 2020/075755 | A1 | 16 April 2020 | US 2021/0387396 A1 claims 1-2, paragraphs [0013]-[0016], [0018]-[0019], [0029]-[0030], [0035], [0058], [0078], examples | | | |
| | | | | EP | 3865285 | A1 | |
| | | | | CN | 112955308 | A | |
| JP | 2014-505607 | A | 06 March 2014 | US 2013/0270736 A1 claim 1, paragraphs [0012], [0023]-[0024], fig. 1 | | | |
| | | | | WO | 2012/096506 | A2 | |
| | | | | EP | 2664447 | A2 | |
| | | | | KR | 10-2012-0090780 | A | |
| | | | | CN | 103313841 | A | |
| JP | 2017-001371 | A | 05 January 2017 | (Family: none) | | | |
| WO | 2022/102706 | A1 | 19 May 2022 | US 2024/0001652 A1 entire text, all drawings | | | |
| | | | | EP | 4245533 | A1 | |
| | | | | CN | 116490359 | A | |
| | | | | KR | 10-2023-0098863 | A | |
| WO | 2022/102705 | A1 | 19 May 2022 | US 2024/0009975 A1 entire text, all drawings | | | |
| | | | | EP | 4245532 | A1 | |
| | | | | CN | 116507493 | A | |
| | | | | KR | 10-2023-0098862 | A | |

Form PCT/ISA/210 (patent family annex) (July 2022)

38

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2023047359 A
- WO 202075755 A

- WO 6845001 A